# FASCICULE DE BREVET EUROPEEN

(11) **EP 4 195 207 B1**
(45) Date de publication et mention de la délivrance du brevet: **28.08.2024**
(21) Numéro de dépôt: 22211794.7
(22) Date de dépôt: 06.12.2022
(51) Int. Cl.: G11C 11/22, G11C 13/00, H10N 70/20

(54) **MÉMOIRES NON VOLATILES À TECHNOLOGIES MIXTES OXRAM/FERAM**
NICHTFLÜCHTIGE SPEICHER IN OXRAM/FERAM-MISCHTECHNOLOGIE
OXRAM/FERAM MIXED TECHNOLOGY NONVOLATILE MEMORIES

(30) Priorité: 10.12.2021 FR 2113286
(43) Date de publication de la demande: 14.06.2023
(73) Titulaire: Commissariat à l'énergie atomique et aux énergies alternatives, 75015 Paris (FR)
(72) Inventeur: RUMMENS, François, 38054 Grenoble (FR); MESQUIDA, Thomas, 38054 Grenoble (FR); GRENOUILLET, Laurent, 38054 Grenoble (FR); VALENTIAN, Alexandre, 38054 Grenoble (FR); VIANELLO, Elisa, 38054 Grenoble (FR)
(74) Mandataire: Atout PI Laplace

(56) Documents cités:
- CN-A- 113 540 099
- US-A1- 2020 168 264
- US-A1- 2021 408 021
- COVI E ET AL: "Ferroelectric Tunneling Junctions for Edge Computing", 2021 IEEE INTERNATIONAL SYMPOSIUM ON CIRCUITS AND SYSTEMS, 22-28 MAY 2021, DAEGU, KR, 22 May 2021 (2021-05-22), XP033933573, DOI: 10.1109/ISCAS51556.2021.9401800
- MAX B ET AL: "Interplay between ferroelectric and resistive switching in doped crystalline HfO2", JOURNAL OF APPLIED PHYSICS, vol. 123, 134102, 4 April 2018 (2018-04-04), XP012227531, DOI: 10.1063/1.5015985

## Description

### Champ d'application

L'invention concerne généralement des cellules mémoires non volatiles configurables pour stocker des données manipulées par des calculateurs pour exécuter un algorithme de calcul. L'algorithme de calcul exécuté nécessite un nombre considérable d'opérations d'écriture et/ou de lecture dans les cellules mémoires selon l'invention.

### Problème soulevé

Dans le domaine des calculateurs embarqués exécutant un algorithme de calcul impliquant un nombre grandissant de variables numériques, les puces électroniques nécessitent une importante capacité mémoire pour stocker les variables de calcul. Ces algorithmes de calcul peuvent implémenter plusieurs phases de calcul : une première phase au cours de laquelle les variables manipulées subissent de nombreuses modifications et une seconde phase au cours de laquelle les mêmes variables sont figées ou subissent peu de modifications.

Différents types de mémoires non volatiles peuvent être utilisés pour réaliser les moyens de stockage des variables de calcul d'un circuit calculateur. Cependant, les différentes technologies de mémoires non-volatiles présentent des caractéristiques différentes de fiabilité et de robustesse face à un nombre considérable d'opérations de lecture et d'écriture subies. Pour qualifier la robustesse des différentes technologies de mémoires, on définit les caractéristiques suivantes :
- On entend par « cyclabilité en écriture » le nombre maximal de cycles d'écriture subis par une cellule mémoire avant sa défaillance structurelle. Il s'agit alors d'un critère de caractérisation de la robustesse technologique des cellules mémoire face à un nombre intense d'opérations d'écriture ;
- On entend par « endurance en lecture » le nombre maximal de cycles de lecture subis par une cellule mémoire avant sa défaillance structurelle. Il s'agit alors d'un critère de caractérisation de la robustesse technologique des cellules mémoire face à un nombre intense d'opérations de lecture ;
- On entend par « énergie de lecture » l'énergie nécessaire pour lire un bit de la cellule mémoire ; elle s'exprime en Joule par bit. Il s'agit alors d'un critère de caractérisation de la performance énergétique des cellules mémoire lors de la réalisation d'une opération de lecture ;
- On entend par « énergie d'écriture » l'énergie nécessaire pour écrire un bit de la cellule mémoire; elle s'exprime en Joule par bit. Il s'agit alors d'un critère de caractérisation de la performance énergétique des cellules mémoire lors de la réalisation d'une opération d'écriture.

L'augmentation considérable du nombre d'opérations de lecture et d'écriture pour implémenter les algorithmes de calcul est très énergivore pour un système dédié à une application mobile (téléphonie, véhicule autonome, robotique..). Il existe donc un besoin pour des calculateurs permettant de satisfaire aux contraintes des systèmes embarqués et des applications visées.

Dans ce contexte, un problème technique à résoudre est l'amélioration de la performance énergétique et de la robustesse technologique des moyens de stockages pour un circuit calculateur apte à réaliser une première phase de fonctionnement nécessitant un grand nombre d'opérations d'écriture dans les moyens de stockage et apte à réaliser une seconde phase de fonctionnement nécessitant un grand nombre d'opérations de lecture desdits moyens de stockage.

### Art antérieur/ Restrictions de l'état de l'art

Un dispositif de matrice mémoire intégrant des cellules ReRAM 1T-1R et des cellules FeRAM 1T-1C est connu de CN 113540099 A (correspondant à US 2021/0408021 A1), par exemple. La publication scientifique intitulée « Interplay between ferroelectric and résistive switching in doped crystalline HfO2 » de B. Max et al, Journal of Applied Physics 123, 134102 (2018), décrit un composant mémoire compatible avec un fonctionnement en mémoire résistive à filament et un fonctionnement en mémoire ferroélectrique. La publication se limite à décrire le composant mémoire d'un point de vue physique en tant que composant élémentaire. La publication ne présente pas une implémentation spécifique dans un circuit de stockage de données embarqué dans un circuit calculateur configurable selon les spécificités de la phase de calcul réalisée en matière de nombre d'opérations de lecture et d'écriture.

### Réponse au problème et apport solution

Pour répondre au problème technique lié à l'amélioration de la performance énergétique et de la robustesse technologique des moyens de stockages d'un circuit calculateur destiné à exécuter un algorithme de calcul sur des données numériques, l'invention propose un circuit de stockage de données comprenant une matrice de cellules mémoire non volatiles et configurables selon deux configurations de fonctionnement. La première configuration correspond à un fonctionnement en mémoire ferroélectrique à polarisation électrique variable (FeRAM) et la seconde configuration correspond à un fonctionnement en mémoire résistive à filament conducteur variable (OxRAM ou ReRAM). En effet, d'une part la technologie de mémoires ferroélectriques à polarisation électrique variable (FeRAM) présente une forte endurance en écriture et une basse énergie d'écriture le rendant plus adapté pour réaliser une opération nécessitant plusieurs itérations d'écriture des données stockées. D'autre part, la technologie de mémoires résistive à filament conducteur variable (OxRAM ou ReRAM) présente une forte endurance en lecture et une basse énergie en lecture le rendant plus performant pour réaliser une opération de calcul nécessitant un nombre considérable de lectures des données stockées .

Les cellules mémoires selon l'invention sont réalisées par le même empilement de couches minces sur un même substrat semiconducteur pour les deux configurations de fonctionnement permettant une implémentation dense des cellules mémoires à technologie hybride dans le même plan mémoire. Cela offre l'avantage d'une réduction de la surface du circuit de stockage de données tout en ayant un fonctionnement adaptable selon la phase exécutée par le calculateur en terme de prépondérance du nombre d'opérations de lecture ou d'écriture.

L'invention propose en outre un procédé de commande permettant de configurer le passage de la première configuration à la seconde configuration des cellules mémoires de manière à convertir les données stockées selon la configuration ferroélectrique à des données stockées selon la configuration résistive.

Enfin, nous allons décrire l'invention dans le contexte applicatif d'un réseau de neurones artificiels à titre illustratif sans perte de généralité. Les caractéristiques de l'invention restent valables pour tout calculateur d'exécution d'algorithmes présentant deux phases de fonctionnement tel que la première configuration nécessite un nombre important d'opérations d'écriture (ou mise à jour) des données stockées et tel que la seconde configuration nécessite un nombre important d'opérations de lecture desdites données.

### Résumé /Revendications

L'invention a pour objet un circuit de stockage de données comprenant une matrice de cellules mémoire, de N lignes et M colonnes réalisée sur un substrat semi-conducteur, comprenant :
- Pour chaque ligne un premier noeud d'entrée configuré pour recevoir un signal de sélection ;
- au moins un second noeud d'entrée configuré pour recevoir une première tension d'écriture ;
- Pour chaque colonne un noeud d'entrée/sortie configuré pour recevoir une seconde tension d'écriture et fournir une tension de lecture ;
- les cellules mémoire étant configurables et non volatiles ; chacune étant destinée à fonctionner selon l'une quelconque parmi deux configurations de fonctionnement ; la première configuration de fonctionnement correspondant à une mémoire ferroélectrique à polarisation électrique variable ; et la seconde configuration de fonctionnement correspondant une mémoire résistive à filament conducteur variable ;
chaque cellule mémoire comprenant :
- un empilement de couches minces selon l'ordre suivant : une première couche en un matériau électriquement conducteur formant une électrode inférieure, une seconde couche en un matériau diélectrique et ferroélectrique, une troisième couche en matériau électriquement conducteur formant une électrode supérieure connecté au second noeud d'entrée associé à la colonne de ladite cellule mémoire ;
- un transistor de sélection ayant une grille connectée au premier noeud d'entrée associé à la ligne de ladite cellule mémoire et reliant l'électrode inférieure au noeud d'entrée/sortie associé à la colonne de ladite cellule mémoire.
Le circuit de stockage de données est configuré pour réaliser, à chaque transition d'une configuration de fonctionnement, dénommée configuration de départ, vers l'autre configuration de fonctionnement, dénommée configuration d'arrivée:
- la lecture de chaque cellule mémoire selon la configuration de départ et le stockage temporaire d'un signal de lecture résultant ;
- l'application d'une tension de transformation sur chaque cellule mémoire ;
- la conversion de chaque signal de lecture selon la configuration de départ en un signal d'écriture compatible avec la configuration d'arrivée ;
- la réécriture de chaque cellule mémoire à partir des signaux d'écriture compatibles avec la configuration de départ.

Selon un aspect particulier de l'invention, le circuit de stockage de données comprend en outre :
- un circuit d'écriture pour écrire dans chaque cellule mémoire en fournissant la première ou la seconde tension d'écriture à partir d'un signal de contrôle d'écriture; chacune des tensions d'écriture étant adaptables selon la configuration de fonctionnement choisie; la durée et/ou l'amplitude de ladite tension d'écriture associée à la première configuration de fonctionnement étant inférieure à celle associée à la seconde configuration de fonctionnement;
- un circuit de lecture pour fournir un signal de lecture pour chaque cellule mémoire sélectionnée.

Selon un aspect particulier de l'invention, le circuit de stockage de données comprend en outre:
- au moins une mémoire de stockage intermédiaire destinée à stocker temporairement chaque signal de lecture lorsque la première configuration est choisie ;
- des moyens de contrôle pour commander les circuits de lecture et le circuit d'écriture selon la configuration choisie et fournir le signal de sélection de la ligne.

Selon un aspect particulier de l'invention, les moyens de contrôle comprennent un circuit de conversion configuré pour convertir, pour chaque cellule mémoire, le signal de lecture résultant de la première configuration de fonctionnement en un signal de contrôle d'écriture compatible avec la seconde configuration de fonctionnement.

Selon un aspect particulier de l'invention, le circuit d'écriture est configuré pour appliquer sur chaque second noeud d'entrée une tension électrique de transformation pour former un filament conducteur dans la deuxième couche partant de la troisième couche dans chaque cellule mémoire. Ledit filament correspond à un état résistif bas.

Selon un aspect particulier de l'invention, l'au moins une mémoire de stockage intermédiaire est destinée en outre à stocker chaque signal de lecture lorsque la seconde configuration est choisie. Le circuit de conversion est configuré pour convertir, pour chaque cellule mémoire, le signal de lecture résultant de la seconde configuration de fonctionnement en un signal de contrôle d'écriture compatible avec la première configuration de fonctionnement.

Selon un aspect particulier de l'invention, le circuit de lecture comprend une pluralité de circuits de lecture élémentaires comprenant chacun :
un comparateur pour comparer la tension de lecture et une tension de référence afin de fournir le signal de lecture de la cellule mémoire en cours de lecture.

Selon un aspect particulier de l'invention, l'au moins une mémoire de stockage intermédiaire est une bascule synchrone.

Selon un aspect particulier de l'invention, le circuit de lecture pour chaque colonne est configuré pour réaliser une opération de lecture en exécutant les étapes suivantes :
- sélectionner la cellule mémoire à lire en mettant à l'état passant le transistor de sélection correspondant à ladite cellule mémoire ;
- initialiser le noeud d'entrée/sortie associé à ladite colonne à une tension nulle ;
- appliquer une impulsion de lecture sur le second noeud d'entrée associé à ladite colonne afin de charger le noeud d'entrée/sortie associé à la même colonne ;
- comparer la tension de lecture sur le noeud d'entrée/sortie avec la tension de référence.

Selon un aspect particulier de l'invention, le circuit de lecture et l'au moins une mémoire de stockage intermédiaire sont réalisées par un seul circuit de détection et de stockage comprenant :
- une bascule à verrou ayant deux noeuds d'entrée/sortie ;
- un premier noeud d'entrée étant destiné à recevoir la tension de référence et étant connecté au premier noeud d'entrée/sortie de la bascule à verrou à travers un premier interrupteur ;
- un second noeud d'entrée étant destiné à recevoir la tension de lecture et étant connecté au second noeud d'entrée/sortie de la bascule à verrou à travers un second interrupteur.
La bascule à verrou est connectée à un noeud d'alimentation à travers un premier transistor de contrôle et à la masse électrique à travers un second transistor de contrôle.

Selon un aspect particulier de l'invention, le circuit de lecture pour chaque colonne est configuré pour réaliser une opération de lecture en exécutant les étapes suivantes :
- sélectionner la cellule mémoire à lire en activant le transistor de sélection correspondant à ladite cellule mémoire ;
- initialiser le noeud d'entrée/sortie associé à ladite colonne à une tension nulle ;
- mettre le premier et le second interrupteur à un état passant et mettre le premier et le second transistor de contrôle à un état bloquant afin de désactiver la bascule à verrou ;
- appliquer une impulsion de lecture sur le second noeud d'entrée associé à ladite colonne afin de charger le noeud d'entrée/sortie associé à la même colonne ;
- mettre le premier et le second interrupteur à un état passant afin de comparer la tension de lecture sur le noeud d'entrée/sortie avec la tension de référence et fournir le signal de lecture ;
- mettre le premier et le second interrupteur à un état bloquant afin de stocker temporairement le signal de lecture.

Selon un aspect particulier de l'invention, le circuit d'écriture est configuré pour réécrire les données lues dans une cellule mémoire après chaque opération de lecture lorsque la première configuration est choisie.

Selon un aspect particulier de l'invention, le circuit d'écriture est configuré pour appliquer une tension d'écriture présentant une amplitude et/ou une durée suffisante pour établir un filament conducteur traversant un état résistif bas irréversible.

Selon un aspect particulier de l'invention, la première et la troisième couche sont réalisées en nitrure de titane. La deuxième couche est réalisée en oxyde d'hafnium dopé avec du silicium ou réalisée en HfZrO₂.

L'invention a également pour objet un calculateur pour exécuter un algorithme de calcul impliquant une pluralité de variables numériques selon au moins deux phases de fonctionnement. La première phase de fonctionnement implique essentiellement des opérations d'écriture de la variable numérique. La seconde phase de fonctionnement implique essentiellement des opérations de lecture de la variable numérique. Ledit calculateur comprend un circuit de stockage de données selon l'invention pour stocker les variables numériques et dans lequel :
- les cellules mémoires sont configurées par les moyens de contrôle pour fonctionner selon la première configuration lors de l'exécution de la première phase de fonctionnement ;
- les cellules mémoires sont configurées par les moyens de contrôle pour fonctionner selon la seconde configuration lors de l'exécution de la seconde phase de fonctionnement.

Selon un aspect particulier de l'invention, le calculateur est configuré pour mettre en oeuvre un réseau de neurones artificiels, le réseau de neurones étant composé d'une succession de couches étant chacune constituée d'un ensemble de neurones, chaque couche étant associée à un ensemble de coefficients synaptiques. Les variables numériques sont les coefficients synaptiques du réseau de neurones. La première phase de fonctionnement est une phase d'apprentissage. La seconde phase de fonctionnement est une phase d'inférence.

L'invention a également pour objet un procédé de commande d'un circuit de stockage selon l'invention pour piloter le passage de la première configuration à la seconde configuration. Le procédé selon l'invention comprend les étapes suivantes pour chaque ligne de la matrice de mémoires :
i. sélectionner la ligne de la matrice de cellules mémoire via le signal de sélection;
ii. lire chaque cellule mémoire et stocker chaque signal de lecture de la ligne dans les mémoires de stockage intermédiaire de manière à détecter le sens de la polarisation électrique de chaque cellule mémoire ;
iii. appliquer sur chaque second noeud d'entrée de ladite ligne une tension électrique de transformation afin de former un filament conducteur dans la deuxième couche partant de la troisième couche dans chaque cellule mémoire; ledit filament correspondant à un état résistif haut,
iv. convertir les signaux de lecture stockés dans les mémoires de stockage intermédiaire pendant le fonctionnement selon la première configuration à des signaux de contrôle d'écriture compatibles avec la seconde configuration ;
v. écrire dans les cellules mémoires de ladite ligne selon les signaux de contrôle d'écriture compatibles avec la seconde configuration de manière à faire varier la longueur du filament conducteur formé.

### Brève Description des Dessins

D'autres caractéristiques et avantages de la présente invention apparaîtront mieux à la lecture de la description qui suit en relation aux dessins annexés suivants.
[Fig. 1a] illustre une vue en perspective d'un mode de réalisation d'une pluralité de structures mémoires non volatiles et configurables selon l'invention.
[Fig. 1b] illustre une vue en coupe d'un composant mémoire selon l'invention selon la première configuration de fonctionnement.
[Fig. 1c] illustre une vue en coupe du composant mémoire selon l'invention selon la seconde configuration de fonctionnement.
[Fig. 2a] illustre une matrice de cellules mémoire selon l'invention.
[Fig. 2b] illustre une modélisation électrique d'une cellule mémoire de la matrice selon l'invention selon la première configuration de fonctionnement.
[Fig. 2c] illustre une modélisation électrique d'une cellule mémoire de la matrice selon l'invention selon la seconde configuration de fonctionnement.
[Fig. 3] illustre un schéma fonctionnel de l'architecture d'un circuit de stockage de données comprenant la matrice de cellules mémoire selon l'invention.
[Fig. 4a] illustre un premier exemple du pilotage de la configuration de fonctionnement des cellules mémoire d'un circuit de stockage de données selon l'invention selon la phase calculatoire exécutée.
[Fig. 4b] illustre un second exemple du pilotage de la configuration de fonctionnement des cellules mémoire d'un circuit de stockage de données selon l'invention selon la phase calculatoire exécutée.
[Fig. 5a] illustre un mécanisme de lecture selon la première configuration de fonctionnement réalisé par un premier mode de réalisation du circuit de lecture.
[Fig. 5b] illustre un mécanisme de lecture selon la seconde configuration de fonctionnement réalisé par le premier mode de réalisation du circuit de lecture.
[Fig. 5c] illustre un mécanisme de lecture alternatif selon la seconde configuration de fonctionnement réalisé par le premier mode de réalisation du circuit de lecture.
[Fig. 6a] illustre un mode de réalisation combiné du circuit de lecture et d'une mémoire de stockage intermédiaire selon l'invention.
[Fig. 6b] illustre un mécanisme de lecture et de stockage selon la seconde configuration de fonctionnement réalisé par le circuit combiné de la figure 6a.

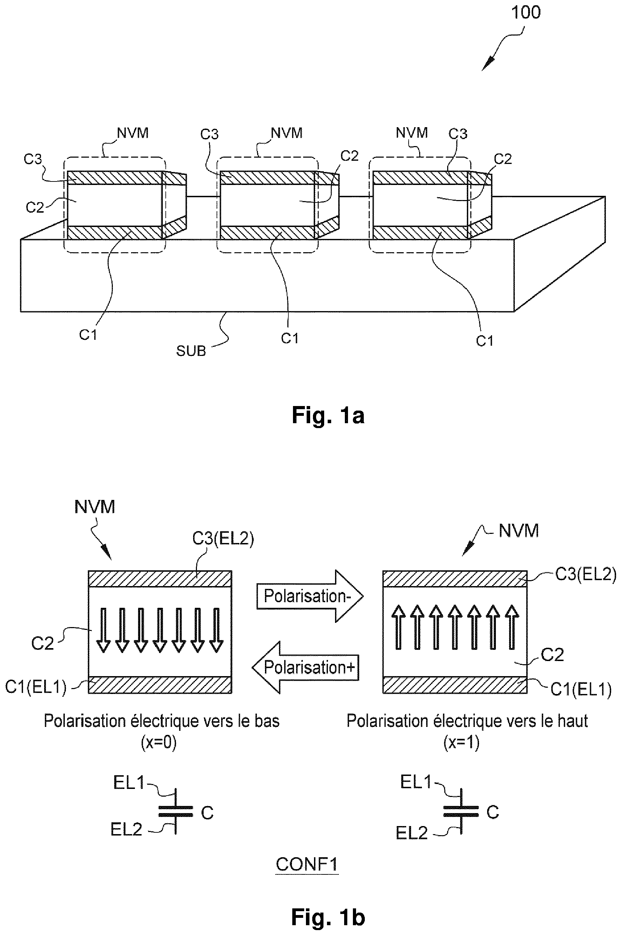

La figure 1a illustre une vue en perspective d'un mode de réalisation d'une pluralité de structures mémoires NVM non volatiles et configurables selon l'invention. Les structures mémoires NVM sont réalisées par un empilement de couches minces sur un même substrat semiconducteur SUB. L'empilement de couches minces est réalisé par les procédés usuels de fabrication microtechnique comprenant le dépôt de couches minces, la gravure, la lithographie et le dopage. Dans le contexte de l'invention, l'ensemble des structures mémoires NVM sont agencées selon une matrice 100. Par souci de simplification de l'illustration, nous représentons uniquement une ligne de trois structures mémoires NVM sur la figure 1a. De plus, une couche de matériau diélectrique (non représentée ici pour simplification), peut séparer les structures mémoire du substrat SUB. Ladite couche est réalisée en dioxyde de silicium SiO₂ par exemple. Dans l'exemple illustré, les structures mémoires NVM sont gravées de sorte qu'elles sont séparées par un espace vide. Alternativement, Il est envisageable de séparer les structures mémoires par des couches de matériau électriquement isolant à la place des espaces vides.

Chaque structure mémoire NVM selon l'invention se compose de l'empilement de couches minces selon l'ordre suivant : une première couche C1 en un matériau électriquement conducteur formant une électrode inférieure EL1 ; une deuxième couche C2 en un matériau diélectrique et ferroélectrique et une troisième couche C3 en matériau électriquement conducteur formant une électrode supérieure EL2. Les caractéristiques des matériaux constituant les couches de structure mémoire NVM permettent une compatibilité de ladite structure avec deux configurations de fonctionnement des technologies des mémoires : la première configuration de fonctionnement CONF1 correspondant à une mémoire ferroélectrique à polarisation électrique variable; et la seconde configuration de fonctionnement CONF2 correspondant à une mémoire résistive à filament conducteur variable. On dénomme la deuxième couche C2 dans la suite de la description la « couche centrale ».

A titre d'exemple et sans perte de généralité, la première couche C1 (et donc l'électrode inférieure EL1) et la troisième couche C3 (et donc l'électrode supérieure EL2) sont réalisées en nitrure de titane TiN. Le choix du nitrure de titane TiN permet d'éviter la formation d'une couche d'oxyde au niveau des deux interfaces avec la couche centrale C2 confinée entre les deux électrodes. L'épaisseur de chacune des couches C1(EL1) et C3 (EL2) est de l'ordre de quelques dizaines de nanomètres, plus particulièrement égale à 100 nm.

A titre d'exemple et sans perte de généralité, la couche centrale C2 est réalisée en oxyde d'hafnium dopé avec du silicium, un matériau diélectrique présentant en outre un comportement ferroélectrique permettant ainsi de réaliser le composant mémoire non-volatile configurable selon l'invention. Le dopage de l'oxyde d'hafnium est configuré de manière à obtenir une structure cristalline présentant une fraction molaire de silicium comprise entre 0.5% et 5%. L'épaisseur de la couche centrale C2 et de l'ordre de quelques nanomètres, plus particulièrement égale à 10 nm.

Alternativement, la couche centrale C2 est réalisée en un alliage Hf_{0.5}Zr_{0.5}O₂ composé d'oxyde d'hafnium et d'oxyde de zirconium présentant lui aussi un comportement ferroélectrique et diélectrique permettant de réaliser le composant mémoire non-volatile configurable selon l'invention.

Alternativement, la couche centrale C2 est constituée d'une hétérostructure réalisée avec des matériaux ferroélectriques et diélectriques.

Nous allons présenter à l'aide des figures 1a et 1b le comportement du composant mémoire NVM selon la configuration de fonctionnement choisie. La figure 1b illustre une vue en coupe du composant mémoire NVM selon la première configuration de fonctionnement CONF1 correspondant à un fonctionnement en mémoire ferroélectrique à polarisation électrique variable (FeRAM). L'empilement de couches minces forme une structure de type MIM (acronyme Metal-Isolant-Metal) agissant comme un élément capacitif à une capacité C. Le caractère ferroélectrique de la couche centrale C2 induit le comportement suivant. Lorsqu'une tension électrique positive est appliquée sur l'électrode supérieure EL2, la polarisation des dipôles électriques de la couche centrale est dirigée dans un sens dit « négatif ». Inversement, lorsqu'une tension électrique positive est appliquée sur l'électrode inférieure EL1, la polarisation des dipôles électriques est dirigée dans un sens dit « positif ». Le sens de la polarisation électrique dans la couche centrale C2 correspond à un état d'équilibre maintenu même en l'absence du champ électrique induit par la tension appliquée sur l'une des électrodes EL1 ou EL2, d'où le fonctionnement en mémoire ferroélectrique.

Ainsi, on choisit la convention suivante à titre d'exemple : lorsqu'un composant mémoire NVM est configuré pour stocker une donnée binaire l'état à logique bas (x= 0) on applique temporairement une tension électrique d'écriture sur l'électrode supérieure EL2 (illustré par polarisation +) de manière à obtenir une polarisation dirigée dans un sens « négatif » dans la couche centrale C2. Inversement, lorsqu'un composant mémoire NVM est configuré pour stocker une donnée binaire à l'état logique haut (x= 1) on applique temporairement une tension électrique d'écriture sur l'électrode inférieure EL1 (illustré par polarisation -) de manière à obtenir une polarisation dirigée dans un sens « positif » dans la couche centrale C2.

L'opération de lecture dans la première configuration de fonctionnement CONF1 est une opération destructrice. En effet, lors d'un accès en lecture, le composant mémoire NVM configuré selon la première configuration de fonctionnement CONF1, reçoit une tension électrique de lecture sur l'électrode supérieure de manière à la réécrire à un état logique bas (x=0). On observe ensuite la dynamique de la transition suite à l'application de la tension de lecture. Si les dipôles électriques de la couche centrale sont préalablement polarisés avec une orientation dans un sens « positif » (x=1), une quantité de charges électriques relativement importante sera émise par le dispositif pendant la transition. Inversement, si les dipôles électriques de la couche centrale sont préalablement polarisés avec une orientation dans un sens « négatif » (x=0), la quantité de charges délivrées pendant la transition est inférieure. Il en résulte que la procédure de lecture consiste à estimer la quantité de charges émises lors d'une polarisation à un état logique bas (x=0) et qu'elle efface donc la valeur logique de la donnée stockée. Ce fonctionnement en deux états de polarisation correspond au fonctionnement d'un élément capacitif.

Alternativement, il est possible de réaliser une opération de lecture dans la première configuration de fonctionnement CONF1 en appliquant une tension électrique de lecture sur l'électrode inférieure de manière à la réécrire à un état logique haut (x=1) et en observant la dynamique de la transition suite à l'application de la tension de lecture. Si la transition nécessite une quantité de charges électriques relativement importante alors l'état précédent de la cellule mémoire est un état logique bas (x=0). Sinon, l'état précédent de la cellule mémoire est un état logique haut (x=1).

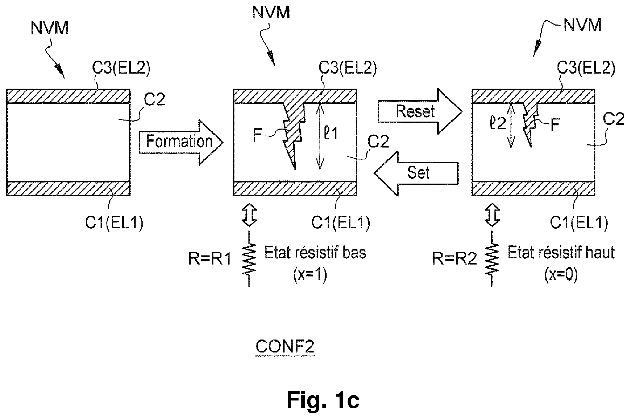

La figure 1c illustre une vue en coupe du composant mémoire NVM selon la seconde configuration de fonctionnement CONF2 correspondant à un fonctionnement en mémoire résistive à filament conducteur variable (ReRAM ou OxRAM). Le fonctionnement selon la seconde configuration CONF2 nécessite la formation d'un filament conducteur F à travers au moins une partie de la couche centrale C2, isolante électriquement.

Initialement, le composant mémoire NVM est une structure de type MIM (métal, isolant, métal) présentant une résistance infinie entre les deux électrodes EL1 et EL2. Afin de configurer le composant mémoire NVM selon la seconde configuration de fonctionnement CONF2 en mémoire résistive, il faut former le filament F partant de l'électrode supérieure EL2 à travers au moins une partie du volume de la couche centrale C2. La formation du filament permet d'obtenir une résistance variable en modulant la longueur I du filament conducteur formé. Pour former le filament, on applique une tension électrique de formation sur l'électrode supérieure EL2. La tension électrique de formation présente une amplitude et/ou une durée suffisamment élevée afin d'entrainer la génération de lacunes d'oxygène dans la couche centrale C2. En effet, la tension électrique de formation appliquée doit dépasser une valeur prédéterminée de manière à arracher des ions oxygène du réseau cristallin de la couche centrale en oxyde métallique qui vont merger vers l'électrode supérieure EL2 former ainsi un filament conducteur F à travers la couche centrale constitué des lacunes d'oxygène.

Une fois le filament conducteur F formé, on obtient le comportement d'élément résistif à une résistance variable R selon la longueur I du filament conducteur F. Lorsqu'une tension électrique positive est appliquée sur l'électrode inférieure EL1, c'est la réaction inverse qui se produit et des ions oxygènes vont venir combler une partie des lacunes d'oxygène formant le filament conducteur. Il en résulte une réduction de la longueur du filament conducteur. Ainsi, la résistance de l'élément résistif augmente. On parle d'un état résistif haut et d'une opération d'écriture de type RESET. Inversement, lorsqu'une tension électrique positive est appliquée sur l'électrode supérieure EL2, la longueur du filament conducteur F s'accroît par le même mécanisme décrit pour l'opération de formation du fil. Ainsi, la résistance de l'élément résistif diminue. On parle d'un état résistif bas et d'une opération d'écriture de type SET.

On choisit la convention suivante à titre d'exemple : lorsqu'un composant mémoire NVM est configuré pour stocker une donnée binaire à l'état logique haut (x= 1) on applique temporairement une tension électrique d'écriture sur l'électrode supérieure EL2 (opération SET) de manière à obtenir un état résistif bas. Inversement, lorsqu'un composant mémoire NVM est configuré pour stocker une donnée binaire à l'état logique bas (x= 0) on applique temporairement une tension électrique d'écriture sur l'électrode inférieure EL1 (opération RESET) de manière à obtenir un état résistif haut.

La lecture d'un composant mémoire NVM pendant le fonctionnement selon la seconde configuration CONF2 consiste à estimer la résistance entre l'électrode supérieure et l'électrode inférieure et à la comparer à une valeur seuil pour déterminer si l'état résistif est un état haut ou bas.

Nous allons dans ce qui suit comparer les ordres de grandeur des différentes tensions appliquées aux électrodes d'un composant mémoire NVM selon l'invention. La tension appliquée est déterminée par une amplitude de cette tension et une durée d'application de cette tension. La tension appliquée lors de la formation du filament présente une durée d'application et/ou une amplitude la plus haute parmi les différentes tensions précitées car elle nécessite l'arrachement des atomes d'oxygène du réseau cristallin de la couche centrale C2. La tension d'écriture compatible avec la seconde configuration CONF2 (lors d'une opération de SET ou RESET), présente une durée d'application et/ou une amplitude inférieure à ceux utilisés pour la formation du filament puisqu'on agit partiellement sur le filament préalablement formé. La tension d'écriture compatible avec la première configuration CONF1 présente une consommation d'énergie inférieure à celle de la tension d'écriture compatible avec la seconde configuration car il s'agit d'une modification des caractéristiques ferroélectriques (on agit sur des électrons) et non d'une modification structurelle à l'échelle atomique. A titre d'exemple non limitatif, on opte pour des tensions d'écriture et de formation sous forme d'impulsions carrées définis par une amplitude et une durée d'application. La tension de formation du filament présente typiquement une amplitude comprise entre 3 V et 4 V pendant une durée de 5 µs à 25 µs. La tension d'écriture compatible avec la seconde configuration CONF 2 présente une amplitude comprise entre 1.7 V et 2.5 V pendant une durée de 100 ns. La tension d'écriture compatible avec la première configuration CONF1 présente typiquement une amplitude de 2 V à 5 V pendant une durée de 5 ns à 100 ns.

Lors de l'écriture, l'intensité du courant parcourant la structure mémoire NVM configurée selon la première configuration CONF1 (comportement capacitif) est inférieure à l'intensité du courant parcourant la structure mémoire NVM configurée selon la seconde configuration CONF2 (comportement résisitif).

Plus généralement, les deux configurations CONF1 et CONF2 présentent des caractéristiques complémentaires en termes de robustesse technologique du composant mémoire et consommation énergétique face à un nombre considérable d'écritures ou de lectures :
D'un point de vue « énergie d'écriture », l'opération d'écriture selon la seconde configuration de fonctionnement CONF2 repose sur une modification physique structurelle de la couche centrale C2 mettant en oeuvre de fortes intensités de courant, typiquement de l'ordre de 100 µA. Ainsi, la seconde configuration de fonctionnement CONF2 nécessite à chaque écriture une énergie importante nécessaire à cette modification structurelle de la matière (environ 100 pJ/bit). D'un autre côté, les opérations d'écriture selon la première configuration de fonctionnement CONF1 consistent plus simplement à appliquer une tension électrique aux bornes de la couche centrale C2 (environ 10 fJ/bit). Dans ce cas, l'opération d'écriture met en oeuvre des intensités de courant plus faibles. Ainsi, la première configuration de fonctionnement CONF1 est moins consommatrice d'énergie à l'écriture que la seconde configuration de fonctionnement CONF2 avec un ratio d'économie d'énergie d'écriture par bit allant jusqu'à 10000.

D'un point de vue « cyclabilité en écriture », la répétition des opérations d'écriture selon la seconde configuration de fonctionnement CONF2 engendre des modifications répétitives de la structure interne de la couche centrale C2 ce qui entraine l'usure matérielle progressive des structures mémoires NVM. On évalue le nombre de cycles d'écriture avant la défaillance d'un composant mémoire fonctionnant uniquement selon la seconde configuration CONF2, est estimé à une valeur comprise entre 10⁵ cycles et 10⁶ cycles. Pour la première configuration de fonctionnement CONF1 le mécanisme d'usure est lié aux mécanismes d'injection de charges. Le nombre de cycles d'écriture avant la défaillance d'un composant mémoire fonctionnant uniquement selon la première configuration CONF1, est estimée à 10¹² cycles.

D'un point de vue « énergie de lecture » et « endurance en lecture », dans un composant mémoire NVM selon la seconde configuration CONF2, la donnée est stockée dans l'état résistif du dispositif. L'opération de lecture consiste donc une simple évaluation de cette grandeur électrique sans modification de l'état physique du composant. Ainsi, la lecture ne dégrade pas la donnée stockée ni la structure matérielle du composant mémoire qui présente dans cette configuration de fonctionnement une endurance en lecture quasi-infinie dans le contexte applicatif d'un calculateur. D'autre part, il a été démontré que l'opération de lecture est destructrice du contenu stocké dans le composant mémoire NVM fonctionnant selon la première configuration CONF1. Le processus de lecture consiste à évacuer la quantité de charges qui parcourent le diélectrique lors d'une commutation. Il en résulte la nécessité d'une opération de réécriture suite à la lecture d'une donnée stockée. Ainsi, l'endurance en écriture qui n'est pas infinie est reportée sur l'endurance de lecture vu que chaque lecture implique une réécriture.

On conclut alors que d'une part, la première configuration de fonctionnement CONF1 du composant mémoire NVM est plus adaptée à une phase de calcul présentant un nombre considérable d'opérations d'écriture des mémoires. D'autre part, la seconde configuration de fonctionnement CONF2 du composant mémoire NVM est plus adaptée à une phase de calcul présentant un nombre considérable d'opérations de lecture des mémoires.

Nous allons dans ce qui suit décrire l'implémentation et la mise en oeuvre du composant mémoire configurable NVM dans un circuit de stockage de données 10 qui peut être implémenté dans un circuit calculateur configuré pour exécuter un algorithme de calcul impliquant une pluralité de variables numériques selon au moins deux phases calculatoires.

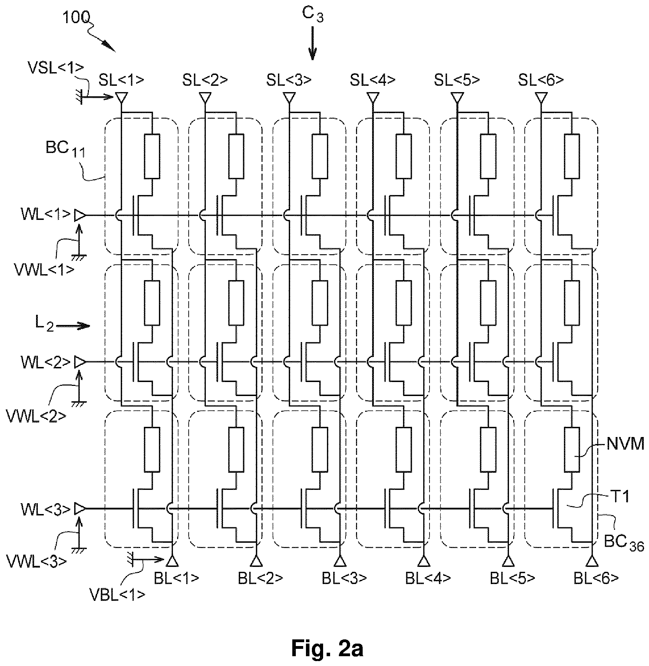

La figure 2a illustre une matrice de cellules mémoire 100 comprenant le composant mémoire NVM selon l'invention. La matrice de cellules mémoires 100 est agencée selon N lignes Lᵢ et M colonnes Cⱼ avec i=1 à N et j=1 à M. Dans le cas de figure illustré la matrice 100 comprend N=3 lignes et M=6 colonnes. La matrice de cellules mémoire 100 comprend pour chaque ligne Lᵢ un premier noeud d'entrée WL<i> configuré pour recevoir un signal de sélection VWL<i>. La matrice de cellules mémoire 100 comprend en outre pour chaque colonne Cⱼ un second noeud d'entrée SL<j> configuré pour recevoir une première tension d'écriture VSL<j>. La matrice de cellules mémoire 100 comprend en outre pour Pour chaque colonne Cⱼ un noeud d'entrée/sortie BL<j> configuré pour recevoir une seconde tension d'écriture VBL<j> et fournir une tension de lecture VBL<j>.

Chaque cellule mémoire BCᵢⱼ de la matrice 100 comprend un composant mémoire NVM configurable et non volatile et un transistor de sélection T1. Nous rappelons que chaque composant mémoire est destiné à fonctionner selon l'une parmi les deux configurations de fonctionnement CONF1 ou CONF2. Le transistor de sélection T1 a une grille connectée au premier noeud d'entrée WL<i> associé à la ligne de ladite cellule mémoire BCᵢⱼ. Le transistor T1 relie l'électrode inférieure EL1 au noeud d'entrée/sortie BL<j> associé à la colonne de ladite cellule mémoire BCᵢⱼ. L'électrode supérieure EL2 du composant mémoire NVM de chaque cellule mémoire BCᵢⱼ est connectée au noeud d'entrée SL<j> associé à la colonne de ladite cellule mémoire BCᵢⱼ . Ainsi, pour les deux configurations de fonctionnement, chaque accès à la cellule mémoire BCᵢⱼ, en écriture ou en lecture, consiste à sélectionner une ligne en activant le transistor T1 via le signal de sélection VWL<i> et appliquer à la paire de noeuds (SL<j> , BL<j>) les tensions et/ou courants nécessaires à la modification ou au sondage de la donnée sauvegardée.

Il s'agit d'un exemple illustratif non limitatif de la matrice de cellules mémoire 100. L'invention reste applicable pour d'autres architectures de matrices de cellules de mémoires. A titre d'exemple alternatif, il est envisageable de réaliser une matrice mémoire tel que le noeud d'entrée SL<j> est partagé entre les cellules mémoire BCᵢⱼ appartenant à la même ligne. Alternativement, il est envisageable de réaliser une matrice mémoire telle que le noeud d'entrée SL<j> est partagé entre toutes les cellules mémoire BCᵢⱼ de la matrice. D'ailleurs, le couple de signaux (WL<j> , BL<j>) décrivant les deux dimensions du plan est suffisant pour sélectionner une cellule mémoire BCᵢⱼ de la matrice en lecture ou en écriture.

Cette implémentation de la matrice des cellules mémoires permet de réduire la surface occupée par la matrice tout en étant compatible avec un fonctionnement selon les deux configurations de fonctionnement nécessitant un accès direct aux électrodes EL1 et EL2 de chaque composant. On obtient ainsi une cellule de type 1R1T ou 1C1T compacte selon la configuration de fonctionnement choisie.

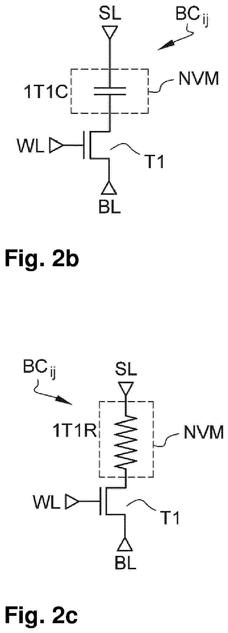

La figure 2b illustre une modélisation électrique d'une cellule mémoire de la matrice selon l'invention selon la première configuration de fonctionnement CONF1. Dans cette configuration de fonctionnement, le composant mémoire NVM se comporte comme un élément capacitif présentant une capacité variable selon la direction de la polarisation électrique de la couche centrale C2. On modélise ainsi la cellule mémoire BCᵢⱼ par une architecture compacte 1C1T avec une action directe sur les électrodes EL1 et EL2 de l'élément capacitif lorsque le transistor T1 est à l'état passant.

La figure 2c illustre une modélisation électrique d'une cellule mémoire de la matrice selon l'invention selon la seconde configuration de fonctionnement CONF2. Dans cette configuration de fonctionnement, le composant mémoire NVM se comporte comme un élément résistif présentant une résistance variable selon la longueur du filament conducteur à travers la couche centrale C2. On modélise ainsi la cellule mémoire BCᵢⱼ par une architecture compacte 1R1T avec une action directe sur les électrodes EL1 et EL2 de l'élément capacitif lorsque le transistor T1 est à l'état passant.

Les transistors T1 sont dimensionnés pour obtenir un courant de saturation suffisant pour fournir les courants électriques forts associés au fonctionnement résistif des cellules mémoire BCᵢⱼ lorsque la seconde configuration de fonctionnement CONF2 est choisie.

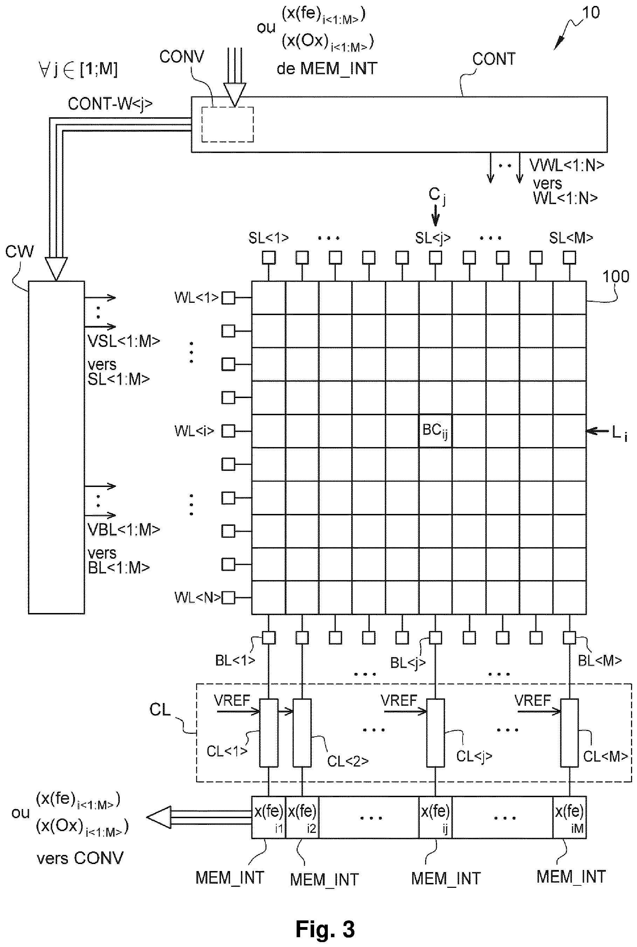

La figure 3 illustre un schéma fonctionnel de l'architecture d'un circuit de stockage de données 10 comprenant la matrice de cellules mémoire 100 selon l'invention. Le circuit de stockage 10 est destiné à être implémenté dans un calculateur d'exécution d'algorithmes présentant deux phases de fonctionnement tel que la première configuration nécessite un nombre important d'opérations d'écriture (ou mise à jour) des données stockées par le circuit de stockage 10 et tel que la seconde configuration nécessite un nombre important d'opérations de lecture desdites données.

Le circuit de stockage de données 10 comprend un circuit d'écriture CW , la matrice de cellule mémoires 100 (de dimensions NxM) destinée à stocker des données de calcul, un circuit de lecture CL , au moins une mémoire de stockage intermédiaire MEM_INT et des moyens de contrôle CONT.

Le circuit d'écriture CW est configuré pour écrire dans chaque cellule mémoire BCᵢⱼ en fournissant la première et/ou la seconde tension d'écriture VSL<j>, VBL<j> à partir d'un signal de contrôle d'écriture cont_w<j>. Chacune des tensions d'écriture VSL<j>, VBL<j> est adaptable selon la configuration de fonctionnement choisie parmi CONF1 ou CONF2. Le circuit d'écriture CW est configuré de manière à fournir au composant mémoire une tension d'écriture compatible avec la première configuration de fonctionnement CONF1 nécessitant une énergie d'écriture inférieure à celle de l'opération d'écriture lorsque la seconde configuration de fonctionnement CONF2 est choisie.

A titre d'exemple de convention de programmation et sans perte de généralité, le circuit d'écriture CW est configuré pour appliquer une tension d'écriture positive VSL<j> sur l'électrode supérieure EL2 du composant mémoire via le noeud SL<j> afin d'écrire une donnée à l'état logique haut (x=1) lorsque la seconde configuration CONF2 est choisie. Le circuit d'écriture CW est configuré pour appliquer une tension d'écriture positive VBL<j> sur l'électrode inférieure EL1 du composant mémoire via le noeud BL<j> afin d'écrire une donnée à l'état logique bas (x=0) lorsque la seconde configuration CONF2 est choisie.

A titre d'exemple de convention de programmation et sans perte de généralité, le circuit d'écriture CW est configuré pour appliquer une tension d'écriture positive VSL<j> sur l'électrode supérieure EL2 du composant mémoire via le noeud SL<j> afin d'écrire une donnée à l'état logique bas (x=0) lorsque la première configuration CONF1 est choisie. Le circuit d'écriture CW est configuré pour appliquer une tension d'écriture positive VBL<j> sur l'électrode inférieure EL1 du composant mémoire via le noeud BL<j> afin d'écrire une donnée à l'état logique haut (x=1) lorsque la première configuration CONF1 est choisie.

Les signaux de commande cont_w<1 :M> sont fournis au circuit d'écriture CW à travers un bus de largeur égale au nombre de colonnes M de la matrice de cellules mémoire 100 afin de pouvoir écrire simultanément sur les cellules mémoires BCᵢⱼ d'une ligne Lᵢ sélectionnée suite à l'activation d'un signal de sélection prédéterminé VWLᵢ.

A titre d'exemple non limitatif, le circuit de lecture CL comprend une pluralité de circuits de lecture élémentaires CL<j>, qui sont configurés pour fournir un signal de lecture de la donnée stockée (x(fe)ᵢⱼ ou x(ox)ᵢⱼ) pour chaque cellule mémoire selon le résultat de comparaison de la tension de lecture VBL<j> avec une tension de référence prédéterminée VREF. A titre d'exemple, la tension de lecture appliquée sur le noeud BL<j> est sous forme d'impulsion. Le signal de référence VREF est généré par une source de tension externe non présentée par souci de simplification. Il est envisageable de déterminer la valeur de la tension de référence selon la configuration de fonctionnement choisie pour adapter le seuil qui détermine l'état logique de la donnée stockée en lecture.

Chaque circuit de lecture élémentaire CL<j>, est associé à une colonne de la matrice de cellules mémoire de même rang et il est connecté au noeud d'entrée/sortie BL<j> de la colonne correspondante. Cela permet de lire simultanément les cellules mémoires BCᵢⱼ d'une ligne Lᵢ sélectionnée suite à l'activation d'un signal de sélection prédéterminé VWLᵢ.

Les moyens de contrôle CONT sont destinés à commander les circuits de lecture élémentaires CL<j> et le circuit d'écriture CW selon la configuration de fonctionnement choisie. Les moyens de contrôle CONT génèrent des signaux de contrôle cont_w<1 :M> vers le circuit d'écriture CW de manière à adapter l'amplitude et/ou la durée des tensions d'écriture selon la configuration de fonctionnement choisie. Nous rappelons que la première configuration de fonctionnement CONF1 nécessite moins d'énergie d'écriture que la seconde configuration CONF2.

De plus, les moyens de contrôle CONT sont destinés à fournir la pluralité de signaux de sélection VWL<1 :N> vers les noeuds de sélection WL<1 :N> de manière à choisir une seule ligne Lᵢ lors d'une opération de lecture ou d'écriture.

Les mémoires de stockage intermédiaire MEM_INT sont agencées telles que chaque mémoires de stockage intermédiaire MEM_INT est destinée à stocker temporairement chaque signal de lecture fourni par un circuit de lecture élémentaire CL<j> CL pour chaque cycle de lecture. Les mémoires de stockage temporaire peuvent être réalisées par tout type de mémoires aptes à réaliser cette fonction tel que des registres, des bascules synchrones, des bascules asynchrones et des barrettes mémoires de façon non limitative.

Le stockage temporaire du contenu des cellules mémoires de la ligne Lᵢ lue pendant chaque cycle de lecture est utilisé pour la phase transitoire d'une configuration de fonctionnement à une autre. D'ailleurs, les moyens de contrôle CONT sont destinés en outre à piloter la transition de la première configuration CONF1 vers la seconde configuration CONF2 ou inversement à partir des données stockées dans les mémoires de stockage interne MEM_INT. En effet, les moyens de contrôle CONT comprennent un circuit de conversion CONV configuré pour convertir, pour chaque cellule mémoire, le signal de lecture x(fe)ᵢⱼ résultant de la première configuration de fonctionnement CONF1 en un signal de contrôle d'écriture CONT_W<j> compatible avec la seconde configuration de fonctionnement CONF2. Inversement, le circuit de conversion CONV est configuré pour convertir, pour chaque cellule mémoire, le signal de lecture x(ox)ᵢⱼ résultant de la seconde configuration de fonctionnement CONF2 en un signal de contrôle d'écriture CONT_W<j> compatible avec la première configuration de fonctionnement CONF1. Ainsi, le circuit de conversion CONV sert à traduire le contenu logique des cellules mémoires de la matrice 100 selon une configuration de fonctionnement de départ à des signaux de contrôle d'écriture permettant de générer des tensions d'écriture compatibles en termes d'énergie d'écriture avec la configuration de fonctionnement cible.

Nous allons dans ce qui suit décrire plusieurs exemples de mise en oeuvre du circuit de stockage de données 100 dans un calculateur ayant une première phase de calcul Ph1 présentant un nombre considérable d'opérations d'écriture dans la matrice 100 et une deuxième phase de calcul Ph2 présentant un nombre considérable d'opérations de lecture de la matrice 100.

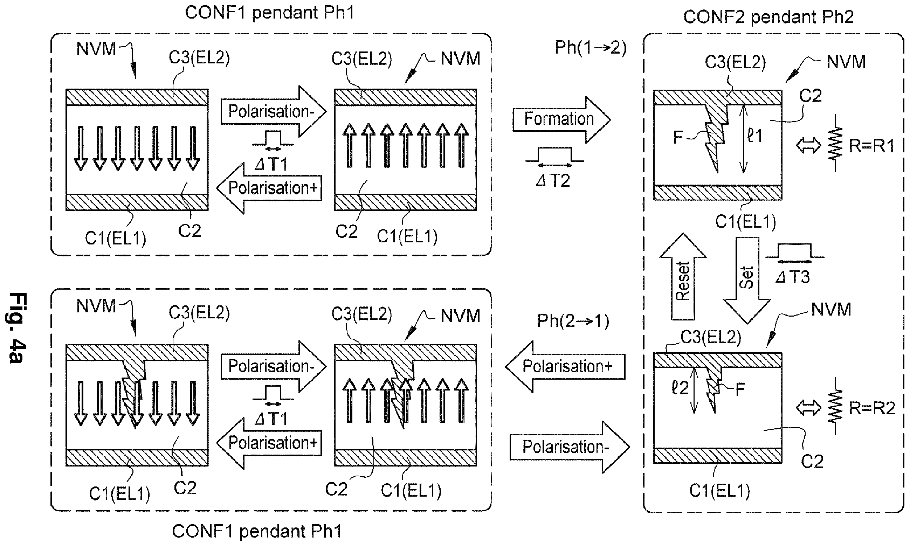

La figure 4a illustre un premier exemple du pilotage de la configuration de fonctionnement des cellules mémoire d'un circuit de stockage de données selon l'invention selon la phase calculatoire exécutée.

L'exécution de l'algorithme de calcul par le circuit calculateur commence par la première phase de calcul PH1 composé de plusieurs itérations de mise à jour des données stockées dans le circuit de stockage 10. Le circuit de stockage de données 10 est configuré par les moyens de contrôle CONT à fonctionner selon la première configuration de fonctionnement CONF1 plus compatible avec un nombre considérable d'écritures dans les cellules mémoires BCᵢⱼ. Ainsi, chaque composant mémoires NVM de la matrice 100 subit une pluralité d'opérations de changement du sens de la polarisation en recevant des tensions d'écriture positives sur l'électrode supérieure EL2 ou inférieure EL1. A titre d'exemple, les tensions d'écriture appliquées par le circuit d'écriture sont des impulsions carrées de durée ΔT1.

Suite à d'une pluralité d'itérations de la première phase de calcul PH1, le circuit de stockage des données 10 reçoit une instruction du circuit calculateur pour l'informer du passage de la première phase de calcul Ph1 à la deuxième phase de calcul Ph2. En réponse à cette instruction, les moyens de contrôle CONT du circuit de stockage des données 10 déclenchent une phase de transition Ph_{1→2} de la première configuration de fonctionnement CONF1 vers la seconde configuration de fonctionnement CONF2. La phase de transition Ph_{1→2 est} constituée de plusieurs itérations d'étapes répétées pour chaque ligne Lᵢ de la matrice de cellules mémoires 100.

La première étape consiste à sélectionner la ligne de la matrice de cellules mémoire 100 en activant le signal de sélection VWL<i> correspondant. Cette étape est réalisée par les moyens de contrôle CONT en activant les transistors de sélection T1 des cellules de la ligne Lᵢ.

La deuxième étape consiste à lire les M cellules mémoire BCᵢⱼ de la ligne sélectionnée par les M circuits de lecture élémentaires CL<j>agencés en bas de chaque colonne de la matrice. Chaque signal de lecture x(fe)ᵢⱼ est stocké dans la mémoire de stockage intermédiaire MEM_INT connectée à la sortie du circuit de lecture élémentaire CL<j>.

La troisième étape consiste à appliquer sur chaque second noeud d'entrée SL<j> de ladite ligne une tension électrique de formation afin de former un filament conducteur dans la deuxième couche C2 partant de la troisième couche C3 dans chaque cellule mémoire BCᵢⱼ. A titre d'exemple, les moyens de contrôle CONT configurent le circuit d'écriture pour appliquer une tension électrique de formation sous forme d'impulsion carrée sur une durée ΔT2 suffisamment longue pour créer des lacunes d'oxygène dans la couche centrale. La durée ΔT2 est 1000 fois plus grande que la durée ΔT1 pour changer la structure interne de la couche centrale C2. On obtient ainsi une formation du filament conducteur dans tous les composants mémoire de la ligne Lᵢ. Avantageusement, les cellules mémoire, où le filament à été formé, sont ensuite initialisées à un état résistif bas (LRS). Alternativement, il est possible d'utiliser une tension de formation présentant une amplitude suffisamment haute pour créer des lacunes d'oxygène dans la couche centrale et donc former le filament conducteur.

La quatrième étape consiste à convertir les signaux de lecture x(fe)ᵢⱼ stockés dans les mémoires de stockage intermédiaire MEM_INT pendant le fonctionnement selon la première configuration CONF1 à des signaux de contrôle d'écriture compatibles avec la seconde configuration CONF2. Cette étape est réalisée par le circuit convertisseur CONV qui réalise la traduction du contenu logique des cellules mémoires de la ligne Lᵢ selon la configuration de fonctionnement de départ à des signaux de contrôle d'écriture permettant de générer des tensions d'écriture compatibles en termes d'énergie d'écriture avec la configuration de fonctionnement CONF2.

La cinquième étape consiste à écrire dans les cellules mémoires de ladite ligne selon les signaux de contrôle d'écriture compatibles avec la seconde configuration CONF2 de manière à faire varier la longueur du filament conducteur formé. A titre d'exemple, le circuit d'écriture CW est configuré pour générer des tensions d'écriture sous forme d'impulsion carrée sur une durée ΔT3 supérieure à la durée ΔT1 du signal d'écriture compatible avec la première configuration CONF1 et inférieure à la durée ΔT2de la tension de formation du filament.

La séquence décrite est réitérée pour toutes les lignes de la matrice 100 jusqu'à finaliser le transfert des données stockées de la première configuration CONF1 à la seconde configuration CONF2.

Une fois la phase de transition terminée, le circuit de stockage fonctionne selon la seconde configuration CONF2 compatible avec l'exécution par le calculateur de la deuxième phase de calcul Ph2 présentant un nombre considérable d'opérations de lecture de la matrice 100. Les circuits de lecture CL sont adaptés à mesurer des variations de résistance dans les composants mémoire NVM et non plus une variation de quantité de charge.

Il est envisageable de programmer le circuit calculateur pour revenir à exécuter la première phase Ph1. Dans ce cas, le circuit de stockage des données 10 reçoit une instruction du circuit calculateur pour l'informer du passage de la deuxième phase de calcul Ph2 à la première phase de calcul Ph1. En réponse à cette instruction, les moyens de contrôle CONT du circuit de stockage des données 10 déclenchent une phase de transition Ph_{2→1} de la seconde configuration de fonctionnement CONF2 vers la première configuration de fonctionnement CONF1. Pendant cette transition le filament conducteur n'est pas détruit car la formation du filament étant irréversible.

La phase de transition Ph_{2→1} est constituée de plusieurs itérations d'étapes répétées pour chaque ligne Lᵢ de la matrice de cellules mémoires 100.

La première étape consiste à sélectionner la ligne de la matrice de cellules mémoire 100 en activant le signal de sélection VWL<i> correspondant. Cette étape est réalisée par les moyens de contrôle CONT en activant les transistors de sélection T1 des cellules de la ligne Lᵢ.

La deuxième étape consiste à lire les M cellules mémoire BCᵢⱼ de la ligne sélectionnée par les M circuits de lecture CL agencés en bas de chaque colonne de la matrice. Chaque signal de lecture x(ox)ᵢⱼ est stocké dans la mémoire de stockage intermédiaire MEM_INT connectée à la sortie du circuit de lecture élémentaire CL<j>.

La troisième étape consiste à appliquer sur chaque second noeud d'entrée SL<j> de ladite ligne une tension électrique de réinitialisation sur l'électrode inférieure EL1 (opération RESET) de manière à réduire la longueur du filament. Cette réinitialisation permet de minimiser la perturbation du fonctionnement selon la première configuration CONF1 (destination de la transition Ph_{2→1}) par le filament résistif provenant de la seconde configuration CONF2 (point de départ de la transition Ph_{2→1}).

Enfin, une étape de conversion des données par le circuit de conversion CONV en lisant dans les mémoires de stockage intermédiaire MEM_INT est réalisée d'une manière similaire à la phase de transition Ph_{1→2} mais avec une traduction dans le sens inverse.

Une fois la phase de transition Ph_{2→1} terminée, le circuit de stockage 10 fonctionne selon la première configuration CONF1 compatible avec l'exécution par le calculateur de la première phase de calcul Ph1 présentant un nombre considérable d'opérations d'écriture de la matrice 100. Les circuits de lecture CL sont adaptés à mesurer des variations de quantité de charge dans les composants mémoire NVM comme expliqué précédemment de manière à exploiter les variations de polarisation et ignorer l'existence du filament conducteur.

L'avantage de cette configuration est qu'elle offre au concepteur une flexibilité de programmation tout en exploitant la compatibilité de chaque configuration de fonctionnement des mémoires selon l'invention avec les besoins en lecture/écriture de la phase de calcul réalisé.

D'une manière générale, la tension électrique de formation lors d'une phase de transition Ph_{1→2} , et la tension électrique de réinitialisation lors d'une phase de transition Ph_{2→1} sont dénommées par le terme « tension de transformation ».

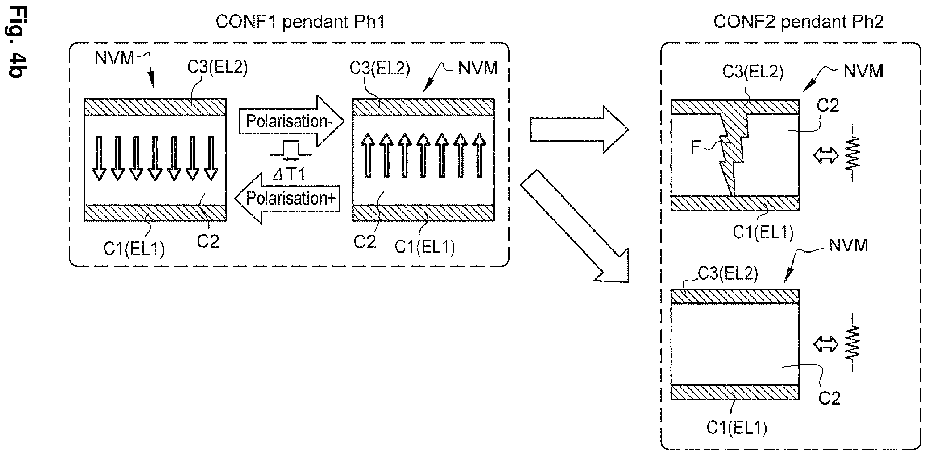

La figure 4b illustre un second exemple du pilotage de la configuration de fonctionnement des cellules mémoire d'un circuit de stockage de données selon l'invention selon la phase calculatoire exécutée.

Le second exemple de la figure 4b diffère du premier exemple en ce qui suit : la phase de transition de la première phase de calcul Ph1 vers la deuxième phase de calcul Ph2 est irréversible. L'algorithme n'exige qu'une seule première phase Ph1 exécutée initialement, ensuite les données stockées par la matrice 100 sont figées lors de la phase de transition Ph_{2→1} .en effet, pendant l'étape de conversion préalablement décrite, le circuit de conversion CONV configure le circuit d'écriture CW à choisir entre les deux possibilités suivantes :
- Si la cellule mémoire BCᵢⱼ stocke une donnée à un état logique haut (x(fe)ᵢⱼ =1), la tension appliquée sur l'électrode supérieure EL2 est maintenue jusqu'à court-circuiter les deux électrodes E1 et E2 via un filament traversant toute l'épaisseur de la couche centrale C2. La cellule mémoire se comporte comme un élément résistif à une faible résistance ;
- Si la cellule mémoire BCᵢⱼ stocke une donnée à un état logique bas (x(fe)ᵢⱼ =0), il n'y a pas besoin de former le filament conducteur et la structure du composant mémoire NVM reste intacte. La cellule mémoire se comporte comme un élément résistif à une résistance infinie.

Un tel usage n'exploite évidemment pas pleinement les capacités de la technologie mixte selon l'invention mais présente l'avantage d'une réduction de la circuiterie d'écriture et d'une meilleure résolution à la lecture des données puisque l'écart entre les deux états résistifs possibles est considérable. En effet, l'état résistif haut correspond à une résistance supérieure à 10 MOhm et l'état résistif bas correspond à une résistance inférieure à 5 kOhm.

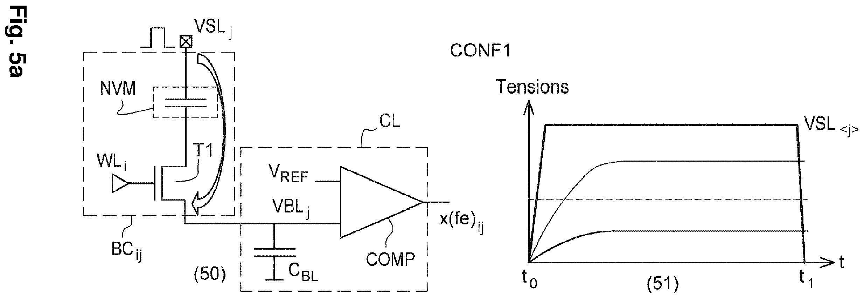

La figure 5a illustre un mécanisme de lecture selon la première configuration de fonctionnement CONF1 réalisé par un premier mode de réalisation du circuit de lecture. Le schéma électrique (50) présente une cellule mémoire BCᵢⱼ en fonctionnement capacitif avec un circuit de lecture élémentaire CL<j> composé d'un circuit comparateur COMP. Le comparateur COMP reçoit sur une première entrée une tension de référence VREF et sur une seconde entrée la tension de lecture VBL<j> à travers le transistor T1 mis à l'état passant. Le circuit comparateur COMP comprend une sortie pour fournir le signal de lecture binaire x(fe)ᵢⱼ selon le résultat de la comparaison. Le signal de référence VREF est généré par une source de tension externe non présentée par souci de simplification. On présente aussi entre le noeud VBL<j> et la masse électrique une capacité parasite C_{BL} qui sert à recevoir les charges fournies par le composant mémoire NVM pendant la lecture. La tension aux bornes de la capacité parasite C_{BL} est proportionnelle à la quantité de charge fournie par le composant capacitif NVM lors de l'opération de lecture.

Le diagramme 51 présente la variation au cours du temps des différents signaux électriques intervenant dans l'opération de lecture selon la première configuration de fonctionnement CONF1.

La procédure de lecture de la cellule mémoire consiste à charger le noeud BL<j> par l'application d'une tension sur le noeud SL<j> , et donc à travers la cellule mémoire BCᵢⱼ ayant un comportement capacitif. La première étape consiste à sélectionner la cellule mémoire à lire en mettant à l'état passant le transistor de sélection (T1) correspondant à ladite cellule mémoire. Ensuite, le noeud de lecture BL<j> associé à la cellule mémoire BCᵢⱼ est initialisé à une tension nulle par le circuit d'écriture CW. Cela correspond à l'état initial du circuit de lecture à l'instant t0 du diagramme 51. Ensuite, une impulsion de lecture est appliquée sur le second noeud d'entrée SL<j> associé à ladite colonne afin de charger le noeud d'entrée/sortie BL<j> associé à la même colonne. En réponse à cette stimulation, la dynamique d'évolution de la tension de lecture VBL<j> varie selon la quantité de charge préalablement stockée dans le composant mémoire NVM agissant comme une capacité : Si la donnée stockée x=1, la tension de lecture VBL<j> augmente selon une pente rapide pendant le chargement de la capacité C_{BL} pour atteindre un niveau d'équilibre supérieur à la tension de référence VREF en régime stationnaire. Si la donnée stockée x=0, la tension de lecture VBL<j> augmente selon une pente lente pendant le chargement de la capacité C_{BL} pour atteindre un niveau d'équilibre inférieur à la tension de référence VREF en régime stationnaire.

Il en résulte que le signal numérique x(fe)ᵢⱼ fourni par la sortie du comparateur représente l'état logique de la donnée préalablement stockée dans le composant mémoire NVM. Si VBL<j> > VREF on observe x(fe)ᵢⱼ =1 sur la sortie du comparateur COMP pour une donnée stockée x=1, Sinon observe x(fe)ᵢⱼ =0.

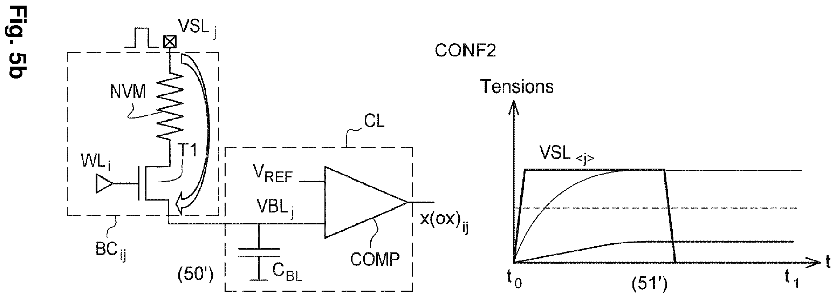

La figure 5b illustre un mécanisme de lecture selon la seconde configuration de fonctionnement CONF2 réalisé par le premier mode de réalisation du circuit de lecture décrit dans la figure 5b. Le schéma électrique 50' présente une cellule mémoire BCᵢⱼ en fonctionnement résistif avec un circuit de lecture élémentaire CL<j> composé d'un circuit comparateur COMP. Le diagramme 51' présente la variation au cours du temps des différents signaux électriques intervenant dans l'opération de lecture selon la seconde configuration de fonctionnement CONF2. La première étape consiste à sélectionner la cellule mémoire à lire en mettant à l'état passant le transistor de sélection T1 correspondant à ladite cellule mémoire. Ensuite, le noeud de lecture BL<j> associé à la cellule mémoire BCᵢⱼ est initialisé à une tension nulle par le circuit d'écriture CW. Cela correspond à l'état initial du circuit de lecture à l'instant t0 du diagramme 51'. Ensuite, une impulsion de lecture est appliquée sur le second noeud d'entrée SL<j> associé à ladite colonne afin de charger le noeud d'entrée/sortie BL<j> associé à la même colonne.

La lecture de la cellule mémoire consiste à estimer la valeur de la résistance du dispositif NVM. Le circuit équivalent obtenu lorsque le transistor T1 est passant est un circuit RC formé par la résistance du composant mémoire NVM en série avec l'élément capacitif parasite C_{BL}. L'élément capacitif C_{BL} initialement déchargé se charge selon une constante de temps ┬=RC_{BL}. On observe ainsi une évolution de la tension BL<j> plus lente avec constante de temps ┬ supérieure lorsque le composant mémoire présente un état résistif haut (HRS). On observe une évolution de la tension BL<j> plus rapide avec constante de temps ┬ inférieure lorsque le composant mémoire présente un état résistif bas (LRS). La durée de l'impulsion appliquée doit être suffisamment courte pour sonder la tension BL<j> lors du régime transitoire et éviter d'atteindre le régime stationnaire de la charge de l'élément capacitif C_{BL}.

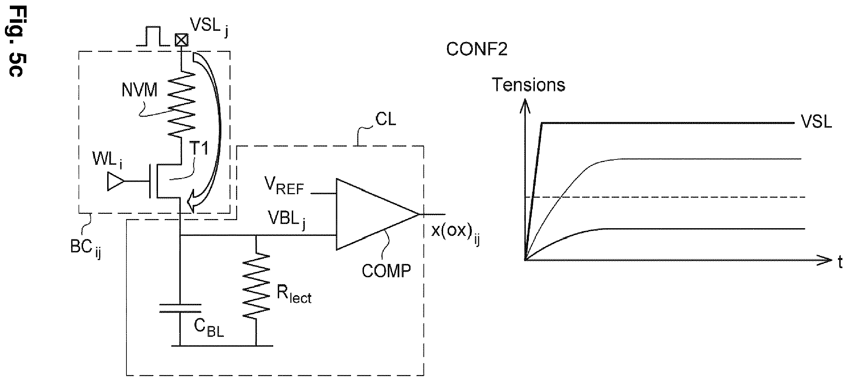

La figure 5c illustre un second mode de réalisation du circuit de lecture élémentaire CL<j> compatible avec la seconde configuration de fonctionnement. Le circuit de lecture illustré dans la figure 5c diffère de celui de la figure 5b par le rajout dans le circuit de lecture élémentaire CL<j>d'une résistance de lecture R_{lect} montée en parallèle avec l'élément capacitif C_{BL}. La résistance de lecture R_{lect} permet de réaliser un pont diviseur de tension tel que la valeur statique de la tension de VBL<j> (régime stationnaire) varie avec la valeur de la résistance du composant mémoire NVM se comportant comme une résistance variable selon la valeur de la donnée stockée. Cette alternative élimine la contrainte d'avoir une impulsion de lecture courte. En effet, il n y a plus besoin de comparer les tensions pendant le régime transitoire car la valeur statique de VBL<j> dépend du ratio de division du pont diviseur de tension réalisé par résistance de lecture R_{lect} et le composant mémoire NVM.

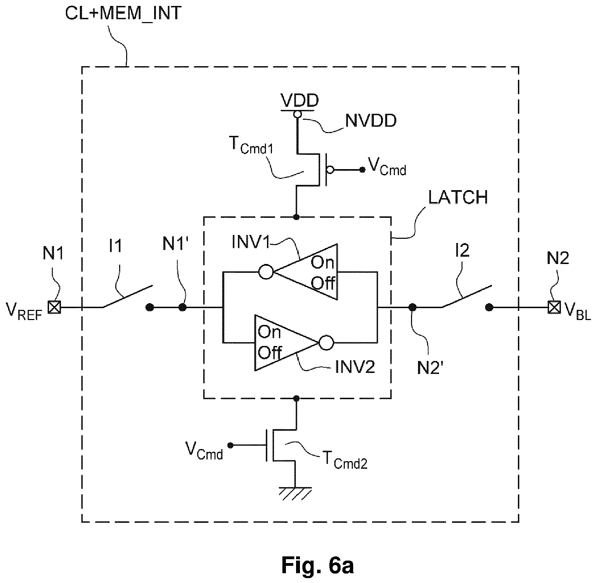

La figure 6a illustre un mode de réalisation combiné du circuit de lecture CL et d'une mémoire de stockage intermédiaire MEM_INT selon l'invention. Il s'agit d'un mode de réalisation où le circuit de lecture CL et la mémoire de stockage intermédiaire MEM_INT qui lui est associée sont réalisés dans un seul circuit CL+MEM_INT dénommé « circuit de détection et de stockage ».

Le circuit de détection et de stockage CL+MEM_INT comprend une bascule à verrou LATCH ayant deux noeuds d'entrée/sortie N'1 et N'2 ; un premier noeud N1 d'entrée destiné à recevoir la tension de référence VREF et connecté au premier noeud d'entrée/sortie N1' de la bascule à verrou à travers un premier interrupteur I1; et un second noeud N2 d'entrée destiné à recevoir la tension de lecture VBL<j> et connecté au second noeud d'entrée/sortie N2' de la bascule à verrou à travers un second interrupteur I2.

La bascule à verrou LATCH consiste en deux circuits inverseurs INV1 et INV2 connectés tête-bêche tel que la sortie de chacun alimente l'entrée de l'autre. On obtient alors un fonctionnement en mémoire intermédiaire au régime stationnaire de la bascule à verrou LATCH. Cela est possible lorsqu'on connecte chacun des deux noeuds N1' et N2' à comparer sur chacune des entrées-sorties des inverseurs. En régime transitoire, l'application de deux tensions différentes sur les deux noeuds N1' et N2' perturbe l'état d'équilibre de la bascule à verrou LATCH qui bascule à un nouveau état d'équilibre selon la comparaison entre les deux tensions différentes appliquées aux noeuds N1' et N2'.

Les deux circuits inverseurs INV1 et INV2 sont connectés à un noeud d'alimentation NVDD à travers un premier transistor de contrôle T_{cmd1}. Les deux circuits inverseurs INV1 et INV2 sont connectés à un noeud de masse électrique à travers un second transistor de contrôle T_{cmd2}. Lorsque le premier noeud de contrôle et le second noeud de contrôle T_{cmd1} et T_{cmd2} sont à l'état passant, les circuits inverseurs INV1 et INV2 sont alimentés par la tension d'alimentation VDD. Lorsque le premier noeud de contrôle et le second noeud de contrôle T_{cmd1} et T_{cmd2} sont à l'état bloquant, les circuits inverseurs INV1 et INV2 sont isolés de la tension d'alimentation VDD et donc la bascule à verrou LATCH est désactivée.

A titre d'exemple, on décrit le déroulement de l'opération de lecture mise en oeuvre par le circuit de détection et de stockage CL+MEM_INT lorsque la première configuration de fonctionnement CONF1 est choisie. La première étape consiste à mettre le premier interrupteur I1 et le second interrupteur I2 à un état bloquant afin d'isoler la bascule à verrou LATCH.

La deuxième étape consiste à la sélection par les moyens de contrôle CONT de la cellule mémoire à lire en activant le transistor de sélection T1 correspondant à ladite cellule mémoire.

La troisième étape consiste à l'initialisation du noeud d'entrée/sortie BL<j> associé à ladite colonne à une tension nulle par le circuit d'écriture CW.

La quatrième étape consiste en l'application par le circuit d'écriture CW d'une tension de lecture, sous forme d'impulsion à titre d'exemple, sur le second noeud d'entrée SL<j> associé à ladite colonne.

Cette étape permet de précharger le noeud d'entrée/sortie BL<j> avec tension de lecture.

Simultanément, le premier et le second interrupteur I1 et I2 sont mis à un état passant, et le premier et le second noeud de contrôle T_{cmd1} et T_{cmd2} sont mis à l'état bloquant. Cela permet de désactiver la bascule à verrou LATCH pour permettre de précharger les noeuds N1' et N2' avec la tension de lecture.

Ensuite, pendant la cinquième étape, le premier et le second interrupteur I1 et I2 sont mis à un état passant et le premier et le second noeud de contrôle T_{cmd1} et T_{cmd2} sont à l'état passant pour activer la bascule à verrou LATCH. Les tensions préalablement préchargées sur les noeuds N1' et N2' perturbent l'équilibre de la bascule à verrou LATCH. Cette perturbation déclenche un mécanisme de comparaison entre la tension de lecture VBL<j> sur le noeud N2' avec la tension de référence VREF sur le noeud N1'. La bascule à verrou LATCH retrouve un état d'équilibre en basculant selon la comparaison entre les deux tensions VREF et VBL<j>. Si VBL<j> est supérieur à VREF le noeud N2' bascule à un état logique haut (x=1) et le noeud N1' bascule à un état logique bas (x=0) Si VBL<j> est inférieur à VREF le noeud N2' bascule à un état logique bas (x=0) et le noeud N1' bascule à un état logique haut (x=1). Le circuit de détection et de stockage CL+MEM_INT réalise ainsi la fonction de circuit comparateur dans le contexte d'une opération de lecture.

L'étape finale consiste à mettre le premier et le second interrupteur I1 et I2 à un état bloquant afin d'isoler la bascule à verrou de son environnement et ainsi stocker temporairement le signal de lecture selon l'état du couple de noeud N1' et N2' résultant de l'opération de comparaison. Le circuit de détection et de stockage CL+MEM_INT réalise ainsi la fonction de stockage temporaire utilisable pour la conversion lors d'une phase de transition d'une configuration de fonctionnement à une autre.

L'avantage de ce mode de réalisation consiste à une réduction de la surface occupée par le circuit par rapport à une implémentation avec un circuit de lecture CL et des mémoires de stockage temporaire MEM_INT réalisés par deux circuits distincts.

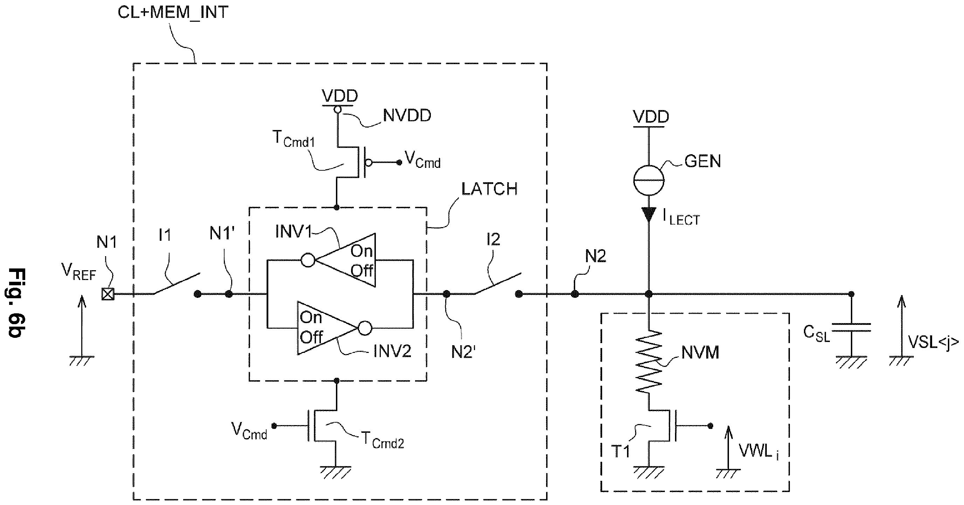

La figure 6b illustre un mécanisme de lecture et de stockage selon la seconde configuration de fonctionnement réalisé par le circuit combiné CR+MEM_INT de la figure 6a.

Dans cet exemple d'illustration, le second noeud N2 d'entrée destiné à recevoir la tension de lecture VBL<j> est connecté à une source de courant GEN constant générant un courant de lecture I_{lect}. Le courant de lecture I_{lect} parcourt l'élément résistif correspondant au composant mémoire NVM lorsque ce dernier fonctionne selon la seconde configuration de fonctionnement CONF2. La source de courant GEN est réalisable par un miroir de courant qui peut être activé ou désactivé selon des signaux de contrôle non représentés par souci de simplification. Le déroulement de l'opération de lecture mise en oeuvre par le circuit de détection et de stockage CL+MEM_INT pour la seconde configuration de fonctionnement CONF2 diffère du déroulement préalablement décrit pour la première configuration de fonctionnement CONF1 en ce qui suit : la quatrième étape consiste à l'activation du miroir de courant GEN de manière à fournir un courant électrique à une intensité prédéterminée parcourant l'élément résistif NVM avec les interrupteurs I1 et I2 à un état passant et l'alimentation des deux inverseurs INV1 et INV2 coupée. Cela permet de précharger le noeud N2' à un potentiel correspondant à la chute de tension provoquée par la résistance de l'élément résistif NVM. La durée de cette étape est prédéterminée par le concepteur de manière à atteindre le régime stationnaire sur le noeud N2'. La durée est de l'ordre de quelques dizaines de nanosecondes.

La cinquième étape consiste à activer l'alimentation des inverseurs INV1 et INV2 et donc activer la bascule à verrou LATCH tout en mettant simultanément les interrupteurs I1 et I2 à un état bloquant de manière à isoler la basculer à verrou LATCH du noeud N2. Les sorties (N1', N2') de la bascule à verrou LATCH basculent donc à un état logique haut ou bas sans charger ou décharger le noeud N2. D'un point de vue consommation, cela présente l'avantage de limiter les variations de la tension *V_{SL}* sur l'électrode supérieure du composant mémoire NVM.

Dans la section suivante, nous allons décrire un exemple non limitatif du contexte applicatif du circuit de stockage de données 10 selon l'invention. Il s'agit des circuits calculateurs de réseau de neurones artificiels. Les réseaux de neurones artificiels constituent des modèles de calcul imitant le fonctionnement des réseaux de neurones biologiques. Les réseaux de neurones artificiels comprennent des neurones interconnectés entre eux par des synapses, chaque synapse est attachée à un poids synaptique (ou coefficient synaptique) implémenté par exemple par des mémoires numériques.

Dans le contexte de l'intelligence artificielle embarquée, les puces électroniques implémentant des réseaux de neurones (profonds et/ou impulsionnels) nécessitent une importante capacité mémoire pour stocker les paramètres de ces réseaux. La mise en oeuvre de réseaux de neurones se décompose en deux phases : l'apprentissage et l'inférence.

La phase d'apprentissage consiste à modifier les poids synaptiques du réseau suivant un algorithme dit d'apprentissage pour les faire converger vers des valeurs telles que le réseau accomplisse la tâche à laquelle il est entraîné. La phase d'inférence consiste à appliquer aux données d'entrée la tâche préalablement apprise.

Dans le cas d'un accélérateur de réseaux de neurones, la vie du système commence par une phase d'apprentissage intensive. Suite à cette opération d'apprentissage le circuit réalise des opérations d'inférence. Il en résulte que les systèmes d'intelligence artificielle, incluant une opération d'apprentissage, doivent en plus implémenter des méthodes de modification de ces paramètres pour répondre à une tache donnée. D'un point de vue moyen de stockage des paramètres du réseau, et plus particulièrement des coefficients synaptiques, les deux opérations susmentionnées présentent une différence importante :
- durant l'apprentissage les poids synaptiques sont régulièrement modifiés, donc les cellules mémoire qui stockent leurs valeurs subissent plusieurs itérations d'opérations de réécriture intensives ;
- durant inférence les poids synaptiques sont figés et les cellules mémoires concernées ne subissent plus d'action d'écriture mais un nombre considérable d'opérations de lecture.

Ainsi, il est possible d'utiliser le circuit stockage de données 10 selon l'invention dans un circuit calculateur de réseau de neurones artificiels de la manière suivante : les cellules mémoires NVM sont destinées à stocker les coefficients synaptiques du réseau. Le circuit stockage de données 10 est configuré selon la première configuration de fonctionnement CONF1 lorsque lors de l'exécution d'une phase d'apprentissage (écriture intensive) par le réseau de neurones artificiels. Le circuit stockage de données 10 est configuré selon la seconde configuration de fonctionnement CONF2 lorsque lors de l'exécution d'une phase d'inférence (lecture intensive) par le réseau de neurones artificiels.

Cette implémentation du circuit stockage de données 10 selon l'invention permet d'améliorer la robustesse technologique, la fiabilité et la consommation énergétique du circuit calculateur de réseau de neurones en adaptant les moyens de stockage avec les contraintes de la phase de calcul réalisée durant la vie du circuit calculateur.

## Revendications

1. Circuit de stockage de données (10) comprenant une matrice de cellules mémoire (BCᵢⱼ), de N lignes (Lᵢ) et M colonnes (Cⱼ) réalisée sur un substrat semi-conducteur, comprenant :
- Pour chaque ligne (Lᵢ) un premier noeud d'entrée (WL<i>) configuré pour recevoir un signal de sélection (VWL<i>) ;
- au moins un second noeud d'entrée (SL<j>) configuré pour recevoir une première tension d'écriture (VSL<j>) ;
- Pour chaque colonne (Cⱼ) un noeud d'entrée/sortie (BL<j>) configuré pour recevoir une seconde tension d'écriture (VBL<j>) et fournir une tension de lecture (VBL<j>) ;
- les cellules mémoire (BCᵢⱼ) étant configurables et non volatiles ; chacune étant destinée à fonctionner selon l'une quelconque parmi deux configurations de fonctionnement (CONF1, CONF2) ;
la première configuration de fonctionnement (CONF1) correspondant à une mémoire ferroélectrique à polarisation électrique variable; et la seconde configuration de fonctionnement (CONF2) correspondant une mémoire résistive à filament conducteur variable ; chaque cellule mémoire (BCᵢⱼ) comprenant :
• un empilement de couches minces (NVM) selon l'ordre suivant : une première couche (C1) en un matériau électriquement conducteur formant une électrode inférieure (EL1), une seconde couche (C2) en un matériau diélectrique et ferroélectrique, une troisième couche (C3) en matériau électriquement conducteur formant une électrode supérieure (EL2) connecté au second noeud d'entrée (SL<j>) associé à la colonne de ladite cellule mémoire (BCᵢⱼ) ;
• un transistor de sélection (T1) ayant une grille connectée au premier noeud d'entrée (WL<i>) associé à la ligne de ladite cellule mémoire (BCᵢⱼ) et reliant l'électrode inférieure (EL1) au noeud d'entrée/sortie (BL<j>) associé à la colonne de ladite cellule mémoire (BCᵢⱼ) ;
le circuit de stockage de données (10) étant configuré pour réaliser, à chaque transition d'une configuration de fonctionnement, dénommée configuration de départ, vers l'autre configuration (CONF1, CONF2) de fonctionnement, dénommée configuration d'arrivée:
- la lecture de chaque cellule mémoire (BCᵢⱼ) selon la configuration de départ et le stockage temporaire d'un signal de lecture résultant ;
- l'application d'une tension de transformation sur chaque cellule mémoire (BCᵢⱼ) ;
- la conversion de chaque signal de lecture selon la configuration de départ en un signal d'écriture compatible avec la configuration d'arrivée ;
- la réécriture de chaque cellule mémoire (BCᵢⱼ) à partir des signaux d'écriture compatibles avec la configuration de départ.

2. Circuit de stockage de données (10) selon la revendication 1 comprenant en outre:
- un circuit d'écriture (CW) pour écrire dans chaque cellule mémoire (BCᵢⱼ) en fournissant la première ou la seconde tension d'écriture (VSL<j>, VBL<j>) à partir d'un signal de contrôle d'écriture (cont_w);
chacune des tensions d'écriture (VSL<j>, VBL<j>) étant adaptables selon la configuration de fonctionnement choisie (CONF1 ,CONF2) ; la durée et/ou l'amplitude de ladite tension d'écriture (VSL<j>, VBL<j>) associée à la première configuration de fonctionnement étant inférieure à celle associée à la seconde configuration de fonctionnement (CONF2) ;
- un circuit de lecture (CL) pour fournir un signal de lecture (x(fe)ᵢⱼ, x(ox)ᵢⱼ) pour chaque cellule mémoire sélectionnée.

3. Circuit de stockage de données (10) selon la revendication 2 comprenant en outre :
- au moins une mémoire de stockage intermédiaire (MEM_INT) destinée à stocker temporairement chaque signal de lecture (x(fe)ᵢⱼ) lorsque la première configuration (CONF1) est choisie ;
- des moyens de contrôle (CONT) pour commander les circuits de lecture et le circuit d'écriture selon la configuration (CONF1, CONF2) choisie et fournir le signal de sélection (VWL<i>) de la ligne (Lᵢ).

4. Circuit de stockage de données (10) selon la revendication 3 dans lequel les moyens de contrôle (CONT) comprennent un circuit de conversion (CONV) configuré pour convertir, pour chaque cellule mémoire, le signal de lecture (x(fe)ᵢⱼ) résultant de la première configuration de fonctionnement (CONF1) en un signal de contrôle d'écriture (CONT_W<j>) compatible avec la seconde configuration de fonctionnement (CONF2).

5. Circuit de stockage de données (10) selon la revendication 4 dans lequel le circuit d'écriture (CW) est configuré pour appliquer sur chaque second noeud d'entrée (SL<j>) une tension électrique de transformation pour former un filament conducteur dans la deuxième couche (C2) partant de la troisième couche (C3) dans chaque cellule mémoire (BCᵢⱼ) ; ledit filament correspondant à un état résistif bas.

6. Circuit de stockage de données (10) selon l'une quelconque des revendications 2 à 5 dans lequel l'au moins une mémoire de stockage intermédiaire (MEM_INT) est destinée en outre à stocker chaque signal de lecture (x(ox)ᵢⱼ) lorsque la seconde configuration (CONF2) est choisie ;
et dans lequel le circuit de conversion (CONV) est configuré pour convertir, pour chaque cellule mémoire, le signal de lecture (x(ox)ᵢⱼ) résultant de la seconde configuration de fonctionnement (CONF2) en un signal de contrôle d'écriture (CONT_W<j>) compatible avec la première configuration de fonctionnement (CONF1).

7. Circuit de stockage de données (10) selon l'une quelconque des revendications 2 à 6 dans lequel le circuit de lecture (CL) comprend une pluralité de circuits de lecture élémentaires (CL<j>) comprenant chacun :
un comparateur (COMP) pour comparer la tension de lecture (VBL<j>) et une tension de référence (VREF) afin de fournir le signal de lecture (x(fe)ᵢⱼ, x(ox)ᵢⱼ) de la cellule mémoire en cours de lecture.

8. Circuit de stockage de données (10) selon l'une quelconque des revendications 2 à 7 dans lequel l'au moins une mémoire de stockage intermédiaire (MEM_INT) est une bascule synchrone.

9. Circuit de stockage de données (10) selon l'une quelconque des revendication 7 ou 8 dans lequel le circuit de lecture pour chaque colonne (Cⱼ) est configuré pour réaliser une opération de lecture en exécutant les étapes suivantes :
- sélectionner la cellule mémoire à lire en mettant à l'état passant le transistor de sélection (T1) correspondant à ladite cellule mémoire ;
- initialiser le noeud d'entrée/sortie (BL<j>) associé à ladite colonne à une tension nulle ;
- appliquer une impulsion de lecture sur le second noeud d'entrée (SL<j>) associé à ladite colonne afin de charger le noeud d'entrée/sortie (BL<j>) associé à la même colonne ;
- comparer la tension de lecture (VBL<j>) sur le noeud d'entrée/sortie (BL<j>) avec la tension de référence (VREF).

10. Circuit de stockage de données (10) selon l'une quelconque des revendications 2 à 6 dans lequel le circuit de lecture (CL) et l'au moins une mémoire de stockage intermédiaire (MEM_INT) sont réalisées par un seul circuit de détection et de stockage (CL+MEM_INT) comprenant :
- une bascule à verrou (LATCH) ayant deux noeuds d'entrée/sortie (N' 1, N' 2) ;
- un premier noeud (N1) d'entrée étant destiné à recevoir la tension de référence (VREF) et étant connecté au premier noeud d'entrée/sortie (N1') de la bascule à verrou à travers un premier interrupteur (I1);
- un second noeud (N2) d'entrée étant destiné à recevoir la tension de lecture (VBL<j>) et étant connecté au second noeud d'entrée/sortie (N2') de la bascule à verrou à travers un second interrupteur (I2).
la bascule à verrou (LATCH) étant connectée à un noeud d'alimentation (NVDD) à travers un premier transistor de contrôle (T_{cmd1}) et à la masse électrique à travers un second transistor de contrôle (T_{cmd2}).

11. Circuit de stockage de données (10) selon la revendication précédente dans lequel le circuit de lecture pour chaque colonne (Cⱼ) est configuré pour réaliser une opération de lecture en exécutant les étapes suivantes :
- sélectionner la cellule mémoire à lire en activant le transistor de sélection (T1) correspondant à ladite cellule mémoire ;
- initialiser le noeud d'entrée/sortie (BL<j>) associé à ladite colonne à une tension nulle ;
- mettre le premier et le second interrupteur (I1, I2) à un état passant et mettre le premier et le second transistor de contrôle (T_{cmd1} T_{cmd2}) à un état bloquant afin de désactiver la bascule à verrou (LATCH) ;
- appliquer une impulsion de lecture sur le second noeud d'entrée (SL<j>) associé à ladite colonne afin de charger le noeud d'entrée/sortie (BL<j>) associé à la même colonne ;
- mettre le premier et le second interrupteur (I1, I2) à un état passant afin de comparer la tension de lecture (VBL<j>) sur le noeud d'entrée/sortie (BL<j>) avec la tension de référence (VREF) et fournir le signal de lecture (x(fe)ᵢⱼ, x(ox)ᵢⱼ) ;
- mettre le premier et le second interrupteur (I1, I2) à un état bloquant afin de stocker temporairement le signal de lecture (x(fe)ᵢⱼ, x(ox)ᵢⱼ).

12. Circuit de stockage de données (10) selon l'une quelconque des revendications 2 à 11 dans lequel le circuit d'écriture est configuré pour réécrire les données lues dans une cellule mémoire après chaque opération de lecture lorsque la première configuration (CONF1) est choisie.

13. Circuit de stockage de données (10) selon l'une quelconque des revendications 2 à 12 dans lequel le circuit d'écriture est configuré pour appliquer une tension d'écriture présentant une amplitude et/ou une durée suffisante pour établir un filament conducteur traversant un état résistif bas irréversible.

14. Circuit de stockage de données (10) selon l'une quelconque des revendications précédentes dans lequel :
- la première (C1) et la troisième (C3) couche sont réalisées en nitrure de titane ;
- la deuxième couche (C2) est réalisée en oxyde d'hafnium dopé avec du silicium ou réalisée en HfZrO₂.

15. Calculateur (CALC) pour exécuter un algorithme de calcul impliquant une pluralité de variables numériques (w) selon au moins deux phases de fonctionnement,
la première phase de fonctionnement (Ph1) impliquant essentiellement des opérations d'écriture de la variable numérique ;
la seconde phase de fonctionnement (Ph2) impliquant essentiellement des opérations de lecture de la variable numérique ;
ledit calculateur (CALC) comprenant un circuit de stockage de données (10) selon l'une quelconque des revendications précédentes pour stocker les variables numériques (w) et dans lequel :
- les cellules mémoires (BCᵢⱼ) sont configurées par les moyens de contrôle (CONT) pour fonctionner selon la première configuration (CONF1) lors de l'exécution de la première phase de fonctionnement ;
- les cellules mémoires (BCᵢⱼ) sont configurées par les moyens de contrôle (CONT) pour fonctionner selon la seconde configuration (CONF2) lors de l'exécution de la seconde phase de fonctionnement.

16. Calculateur (CALC) selon la revendication précédente configuré pour mettre en oeuvre un réseau de neurones artificiels, le réseau de neurones étant composé d'une succession de couches (Cₖ, Cₖ₊₁) étant chacune constituée d'un ensemble de neurones, chaque couche étant associée à un ensemble de coefficients synaptiques (w_{i,j}); dans lequel :
- les variables numériques sont les coefficients synaptiques du réseau de neurones ;
- la première phase de fonctionnement est une phase d'apprentissage ;
- la seconde phase de fonctionnement est une phase d'inférence.

17. Procédé de commande d'un circuit de stockage selon l'une quelconque des revendications 3 à 14 pour piloter le passage de la première configuration (CONF1) à la seconde configuration (CONF2) comprenant les étapes suivantes pour chaque ligne de la matrice de mémoires :
i. sélectionner la ligne de la matrice de cellules mémoire (100) via le signal de sélection (VWL<i>) ;
ii. lire chaque cellule mémoire et stocker chaque signal de lecture (x(fe)ᵢⱼ) de la ligne dans les mémoires de stockage intermédiaire (MEM_INT) de manière à détecter le sens de la polarisation électrique de chaque cellule mémoire ;
iii. appliquer sur chaque second noeud d'entrée (SL<j>) de ladite ligne une tension électrique de transformation afin de former un filament conducteur dans la deuxième couche (C2) partant de la troisième couche (C3) dans chaque cellule mémoire (BCᵢⱼ) ; ledit filament correspondant à un état résistif haut ;
iv. convertir les signaux de lecture (x(fe)ᵢⱼ) stockés dans les mémoires de stockage intermédiaire (MEM_INT) pendant le fonctionnement selon la première configuration (CONF1) à des signaux de contrôle d'écriture compatibles avec la seconde configuration (CONF2) ;
v. écrire dans les cellules mémoires de ladite ligne selon les signaux de contrôle d'écriture compatibles avec la seconde configuration (CONF2) de manière à faire varier la longueur du filament conducteur formé.

## Patentansprüche

1. Datenspeicherschaltung (10), die eine auf einem Halbleitersubstrat realisierte Speicherzellenmatrix (BCᵢⱼ) mit N Zeilen (Lᵢ) und M Spalten (Cⱼ) umfasst, die Folgendes umfasst:
- für jede Zeile (Lᵢ) einen ersten Eingangsknoten (WL<i>), der zum Empfangen eines Auswahlsignals (VWL<i>) konfiguriert ist;
- mindestens einen zweiten Eingangsknoten (SL<j>), der zum Empfangen einer ersten Schreibspannung (VSL<j>) konfiguriert ist;
- für jede Spalte (Cⱼ) einen Eingangs-/Ausgangsknoten (BL<j>), der zum Empfangen einer zweiten Schreibspannung (VBL<j>) und zum Liefern einer Lesespannung (VBL<j>) konfiguriert ist;
- wobei die Speicherzellen (BCᵢⱼ) konfigurierbar und nichtflüchtig sind; wobei jede zum Arbeiten in einer beliebigen von zwei Betriebskonfigurationen (CONF1, CONF2) bestimmt ist;
wobei die erste Betriebskonfiguration (CONF1) einem ferroelektrischen Speicher mit variabler elektrischer Vorspannung entspricht;
und wobei die zweite Betriebskonfiguration (CONF2) einem Widerstandsspeicher mit variablem Leitfilament entspricht;
wobei jede Speicherzelle (BCᵢⱼ) Folgendes umfasst:
• einen Dünnschichtstapel (NVM) in der folgenden Reihenfolge: eine erste Schicht (C1) aus einem elektrisch leitfähigen Material, die eine untere Elektrode (EL1) bildet, eine zweite Schicht (C2) aus einem dielektrischen und ferroelektrischen Material, eine dritte Schicht (C3) aus einem elektrisch leitfähigen Material, die eine obere Elektrode (EL2) bildet, die mit dem der Spalte der Speicherzelle (BCᵢⱼ) zugeordneten zweiten Eingangsknoten (SL<j>) verbunden ist;
• einen Auswahltransistor (T1) mit einem Gate, das mit dem ersten Eingangsknoten (WL<i>) verbunden ist, der der Zeile der Speicherzelle (BCᵢⱼ) zugeordnet ist und die untere Elektrode (EL1) mit dem der Spalte der Speicherzelle (BCᵢⱼ) zugeordneten Eingangs-/Ausgangsknoten (BL<j>) verbindet;
wobei die Datenspeicherschaltung (10) konfiguriert ist zum Durchführen, bei jedem Übergang von einer als Startkonfiguration bezeichneten Betriebskonfiguration zu der als Zielkonfiguration bezeichneten anderen Betriebskonfiguration (CONF1, CONF2), von Folgendem:
- Lesen jeder Speicherzelle (BCᵢⱼ) gemäß der Startkonfiguration und vorübergehendes Speichern eines resultierenden Lesesignals;
- Anlegen einer Transformationsspannung an jede Speicherzelle (BCᵢⱼ):
- Umwandeln jedes Lesesignals gemäß der Startkonfiguration in ein mit der Zielkonfiguration kompatibles Schreibsignal;
- Überschreiben jeder Speicherzelle (BCᵢⱼ) auf der Basis von den mit der Startkonfiguration kompatiblen Schreibsignalen.

2. Datenspeicherschaltung (10) nach Anspruch 1, die ferner Folgendes umfasst:
- eine Schreibschaltung (CW) zum Schreiben in jede Speicherzelle (BCᵢⱼ) durch Liefern der ersten oder der zweiten Schreibspannung (VSL<j>, VBL<j>) auf der Basis eines Schreibsteuersignals (cont_w);
wobei jede der Schreibspannungen (VSL<j>, VBL<j>) gemäß der gewählten Betriebskonfiguration (CONF1, CONF2) anpassbar ist; wobei die Dauer und/oder die Amplitude der der ersten Betriebskonfiguration zugeordneten Schreibspannung (VSL<j>, VBL<j>) geringer ist als die, die der zweiten Betriebskonfiguration (CONF2) zugeordnet ist;
- eine Leseschaltung (CL) zum Liefern eines Lesesignals (x(fe)ᵢⱼ, x(ox)ᵢⱼ) für jede ausgewählte Speicherzelle.

3. Datenspeicherschaltung (10) nach Anspruch 2, die ferner Folgendes umfasst:
- mindestens einen Zwischenspeicher (MEM_INT) zum vorübergehenden Speichern jedes Lesesignals (x(fe)ᵢⱼ), wenn die erste Konfiguration (CONF1) gewählt wird;
- Steuermittel (CONT) zum Steuern der Leseschaltungen und der Schreibschaltung gemäß der gewählten Konfiguration (CONF1, CONF2) und zum Liefern des Auswahlsignals (VWL<i>) der Zeile (Lᵢ).

4. Datenspeicherschaltung (10) nach Anspruch 3, wobei die Steuermittel (CONT) eine Umwandlungsschaltung (CONV) umfassen, die zum Umwandeln, für jede Speicherzelle, des aus der ersten Betriebskonfiguration (CONF1) resultierenden Lesesignals (x(fe)ᵢⱼ) in ein mit der zweiten Betriebskonfiguration (CONF2) kompatibles Schreibsteuersignal (CONT _W<j>) konfiguriert ist.

5. Datenspeicherschaltung (10) nach Anspruch 4, wobei die Schreibschaltung (CW) zum Anlegen einer elektrischen Transformationsspannung an jeden zweiten Eingangsknoten (SL<j>) konfiguriert ist, um in der zweiten Schicht (C2), die von der dritten Schicht (C3) ausgeht, in jeder Speicherzelle (BCᵢⱼ) ein Leitfilament zu bilden; wobei das Filament einem niedrigen Widerstandszustand entspricht.

6. Datenspeicherschaltung (10) nach einem der Ansprüche 2 bis 5, wobei der mindestens eine Zwischenspeicher (MEM_INT) ferner zum Speichern jedes Lesesignals (x(ox)ᵢⱼ) bestimmt ist, wenn die zweite Konfiguration (CONF2) gewählt wird;
und wobei die Umwandlungsschaltung (CONV) zum Umwandeln, für jede Speicherzelle, des aus der zweiten Betriebskonfiguration (CONF2) resultierenden Lesesignals (x(ox)ᵢⱼ) in ein mit der ersten Betriebskonfiguration (CONF1) kompatibles Schreibsteuersignal (CONT _W<j>) konfiguriert ist.

7. Datenspeicherschaltung (10) nach einem der Ansprüche 2 bis 6, wobei die Leseschaltung (CL) eine Vielzahl von elementaren Leseschaltungen (CL<j>) umfasst, die jeweils Folgendes umfassen:
einen Komparator (COMP) zum Vergleichen der Lesespannung (VBL<j>) und einer Referenzspannung (VREF), um das Lesesignal (x(fe)ᵢⱼ, x(ox)ᵢⱼ) der gerade gelesenen Speicherzelle zu liefern.

8. Datenspeicherschaltung (10) nach einem der Ansprüche 2 bis 7, wobei der mindestens eine Zwischenspeicher (MEM_INT) ein synchrones Flipflop ist.

9. Datenspeicherschaltung (10) nach Anspruch 7 oder 8, wobei die Leseschaltung für jede Spalte (Cⱼ) konfiguriert ist zum Durchführen eines Lesevorgangs durch Ausführen der folgenden Schritte:
- Auswählen der zu lesenden Speicherzelle durch Setzen des Auswahltransistors (T1) entsprechend der Speicherzelle in den Durchlasszustand;
- Stellen des der Spalte zugeordneten Eingangs-/Ausgangsknotens (BL<j>) auf eine Null-Spannung;
- Anlegen eines Leseimpulses an den der Spalte zugeordneten zweiten Eingangsknoten (SL<j>), um den derselben Spalte zugeordneten Eingangs-/Ausgangsknoten (BL<j>) zu laden;
- Vergleichen der Lesespannung (VBL<j>) am Eingangs-/Ausgangsknoten (BL<j>) mit der Referenzspannung (VREF).

10. Datenspeicherschaltung (10) nach einem der Ansprüche 2 bis 6, wobei die Leseschaltung (CL) und der mindestens eine Zwischenspeicher (MEM_INT) durch eine einzige Erfassungs- und Speicherschaltung (CL+MEM_INT) gebildet werden, die Folgendes umfasst:
- ein Latch-Flipflop (LATCH) mit zwei Eingangs-/Ausgangsknoten (N'1, N'2);
- einen ersten Eingangsknoten (N1), der zum Empfangen der Referenzspannung (VREF) bestimmt ist und über einen ersten Schalter (11) mit dem ersten Eingangs-/Ausgangsknoten (N1') des Latch-Flipflops verbunden ist;
- einen zweiten Eingangsknoten (N2), der zum Empfangen der Lesespannung (VBL<j>) bestimmt ist und über einen zweiten Schalter (I2) mit dem zweiten Eingangs-/Ausgangsknoten (N2') des Latch-Flipflops verbunden ist;
wobei das Latch-Flipflop (LATCH) über einen ersten Steuertransistor (T_{cmd1}) mit einem Stromversorgungsknoten (NVDD) und über einen zweiten Steuertransistor (T_{cmd2}) mit elektrischer Masse verbunden ist.

11. Datenspeicherschaltung (10) nach dem vorhergehenden Anspruch, wobei die Leseschaltung für jede Spalte (Cⱼ) konfiguriert ist zum Durchführen eines Lesevorgangs durch Ausführen der folgenden Schritte:
- Auswählen der zu lesenden Speicherzelle durch Aktivieren des Auswahltransistors (T1) entsprechend der Speicherzelle;
- Stellen des der Spalte zugeordneten Eingangs-/Ausgangsknotens (BL<j>) auf eine Null-Spannung;
- Setzen des ersten und des zweiten Schalters (I1, I2) in einen Durchlasszustand und Setzen des ersten und des zweiten Steuertransistors (T_{cmd1}, T_{cmd2}) in einen Sperrzustand, um das Latch-Flipflop (LATCH) zu deaktivieren;
- Anlegen eines Leseimpulses an den der Spalte zugeordneten zweiten Eingangsknoten (SL<j>), um den derselben Spalte zugeordneten Eingangs-/Ausgangsknoten (BL<j>) zu laden;
- Setzen des ersten und zweiten Schalters (I1, I2) in einen Durchlasszustand, um die Lesespannung (VBL<j>) am Eingangs-/Ausgangsknoten (BL<j>) mit der Referenzspannung (VREF) zu vergleichen und das Lesesignal (x(fe)ᵢⱼ, x(ox)ᵢⱼ) zu liefern;
- Setzen des ersten und des zweiten Schalters (I1, I2) in einen Sperrzustand, um das Lesesignal (x(fe)ᵢⱼ, x(ox)ᵢⱼ) vorübergehend zu speichern.

12. Datenspeicherschaltung (10) nach einem der Ansprüche 2 bis 11, wobei die Schreibschaltung zum Überschreiben der gelesenen Daten nach jedem Lesevorgang in eine Speicherzelle konfiguriert ist, wenn die erste Konfiguration (CONF1) gewählt wird.

13. Datenspeicherschaltung (10) nach einem der Ansprüche 2 bis 12, wobei die Schreibschaltung zum Anlegen einer Schreibspannung mit einer Amplitude und/oder einer Dauer konfiguriert ist, die ausreicht, um ein Leitfilament herzustellen, das einen irreversiblen niedrigen Widerstandszustand durchläuft.

14. Datenspeicherschaltung (10) nach einem der vorhergehenden Ansprüche, wobei:
- die erste (C1) und die dritte (C3) Schicht aus Titannitrid hergestellt sind;
- die zweite Schicht (C2) aus mit Silizium dotiertem Hafniumoxid hergestellt ist oder aus HfZrO₂ hergestellt ist.

15. Rechner (CALC) zum Ausführen eines Rechenalgorithmus, der eine Vielzahl von numerischen Variablen (w) beinhaltet, gemäß mindestens zwei Betriebsphasen,
wobei die erste Betriebsphase (Ph1) im Wesentlichen Schreibvorgänge der numerischen Variablen beinhaltet;
wobei die zweite Betriebsphase (Ph2) im Wesentlichen Lesevorgänge der numerischen Variablen beinhaltet;
wobei der Rechner (CALC) eine Datenspeicherschaltung (10) nach einem der vorhergehenden Ansprüche zum Speichern der numerischen Variablen (w) umfasst, und wobei:
- die Speicherzellen (BCᵢⱼ) von den Steuermitteln (CONT) zum Arbeiten gemäß der ersten Konfiguration (CONF1) bei der Ausführung der ersten Betriebsphase konfiguriert sind;
- die Speicherzellen (BCᵢⱼ) von den Steuermitteln (CONT) zum Arbeiten gemäß der zweiten Konfiguration (CONF2) bei der Ausführung der zweiten Betriebsphase konfiguriert sind.

16. Rechner (CALC) nach dem vorhergehenden Anspruch, der zum Implementieren eines künstlichen neuronalen Netzwerks konfiguriert ist, wobei das neuronale Netzwerk aus einer Folge von Schichten (Cₖ, Cₖ₊₁) gebildet ist, die jeweils aus einem Satz von Neuronen bestehen, wobei jede Schicht einem Satz von synaptischen Koeffizienten (w_{i,j}) zugeordnet ist; wobei:
- die numerischen Variablen die synaptischen Koeffizienten des neuronalen Netzwerks sind;
- die erste Betriebsphase eine Lernphase ist;
- die zweite Betriebsphase eine Inferenzphase ist.

17. Verfahren zum Steuern einer Speicherschaltung nach einem der Ansprüche 3 bis 14 zum Steuern der Umstellung von der ersten Konfiguration (CONF1) zur zweiten Konfiguration (CONF2), das für jede Zeile der Speichermatrix die folgenden Schritte umfasst:
i. Auswählen der Zeile der Speicherzellenmatrix (100) über das Auswahlsignal (VWL<i>);
ii. Lesen jeder Speicherzelle und Speichern jedes Lesesignals (x(fe)ᵢⱼ) der Zeile in den Zwischenspeichern (MEM_INT), um die Richtung der elektrischen Vorspannung jeder Speicherzelle zu erfassen;
iii. Anlegen einer elektrischen Transformationsspannung an jeden zweiten Eingangsknoten (SL<j>) der Zeile, um in der zweiten Schicht (C2), die von der dritten Schicht (C3) ausgeht, in jeder Speicherzelle (BCᵢⱼ) ein Leitfilament zu bilden; wobei das Filament einem hochohmigen Zustand entspricht;
iv. Umwandeln der während des Betriebs gemäß der ersten Konfiguration (CONF1) in den Zwischenspeichern (MEM_INT) gespeicherten Lesesignale (x(fe)ᵢⱼ) in mit der zweiten Konfiguration (CONF2) kompatible Schreibsteuersignale;
v. Schreiben in die Speicherzellen der Zeile gemäß den mit der zweiten Konfiguration (CONF2) kompatiblen Schreibsteuersignalen, um die Länge des gebildeten Leitfilaments zu variieren.

## Claims

1. A data storage circuit (10) comprising an array of memory cells (BCᵢⱼ), of N rows (Lᵢ) and M columns (Cⱼ), produced on a semiconductor substrate, comprising:
- for each row (Lᵢ), a first input node (WL<i>) configured to receive a selection signal (VWL<i>);
- at least one second input node (SL<j>) configured to receive a first write voltage (VSL<j>);
- for each column (Cⱼ), an input/output node (BL<j>) configured to receive a second write voltage (VBL<j>) and supply a read voltage (VBL<j>);
- the memory cells (BCᵢⱼ) being configurable and non-volatile; each one being intended to operate in either one of two operating configurations (CONF 1, CONF2);
the first operating configuration (CONF1) corresponding to a ferroelectric memory with varying electrical bias;
and the second operating configuration (CONF2) corresponding to a resistive memory with varying conductive filament;
each memory cell (BCᵢⱼ) comprising:
• a stack of thin layers (NVM) in the following order: a first layer (C1) made of an electrically conductive material forming a lower electrode (EL1), a second layer (C2) made of a dielectric and ferroelectric material, a third layer (C3) made of electrically conductive material forming an upper electrode (EL2) connected to the second input node (SL<j>) associated with the column of said memory cell (BCᵢⱼ);
• a selection transistor (T1) having a gate connected to the first input node (WL<i>) associated with the row of said memory cell (BCᵢⱼ) and connecting the lower electrode (EL1) to the input/output node (BL<j>) associated with the column of said memory cell (BCᵢⱼ);
the data storage circuit (10) being configured, upon each transition from one operating configuration, called starting configuration, to the other operating configuration (CONF1, CONF2), called finishing configuration, to perform the following:
- reading each memory cell (BCᵢⱼ) in the starting configuration and temporarily storing a resulting read signal;
- applying a transformation voltage to each memory cell (BCᵢⱼ);
- converting each read signal in the starting configuration into a write signal compatible with the finishing configuration;
- rewriting each memory cell (BCᵢⱼ) based on the write signals compatible with the starting configuration.

2. The data storage circuit (10) according to claim 1, further comprising:
- a write circuit (CW) for writing in each memory cell (BCᵢⱼ) by supplying the first or the second write voltage (VSL<j>, VBL<j>) from a write control signal (cont_w);
each of the write voltages (VSL<j>, VBL<j>) being adaptable in accordance with the chosen operating configuration (CONF1, CONF2); the duration and/or the amplitude of said write voltage (VSL<j>, VBL<j>) associated with the first operating configuration being lower than that associated with the second operating configuration (CONF2);
- a read circuit (CL) for supplying a read signal (x(fe)ᵢⱼ, x(ox)ᵢⱼ) for each selected memory cell.

3. The data storage circuit (10) according to claim 2, further comprising:
- at least one intermediate storage memory (MEM_INT) intended to temporarily store each read signal (x(fe)ᵢⱼ) when the first configuration (CONF1) is chosen;
- control means (CONT) for controlling the read circuits and the write circuit in accordance with the chosen configuration (CONF1, CONF2) and supplying the selection signal (VWL<i>) of the row (Lᵢ).

4. The data storage circuit (10) according to claim 3, wherein the control means (CONT) comprise a conversion circuit (CONV) configured to convert, for each memory cell, the read signal (x(fe)ᵢⱼ) resulting from the first operating configuration (CONF1) into a write control signal (CONT _W<j>) compatible with the second operating configuration (CONF2).

5. The data storage circuit (10) according to claim 4, wherein the write circuit (CW) is configured to apply, to each second input node (SL<j>), an electric transformation voltage to form a conductive filament in the second layer (C2) starting from the third layer (C3) in each memory cell (Bcᵢⱼ); said filament corresponding to a low resistive state.

6. The data storage circuit (10) according to any one of claims 2 to 5, wherein the at least one intermediate storage memory (MEM_INT) is further intended to store each read signal (x(ox)ᵢⱼ) when the second configuration (CONF2) is chosen;
and wherein the conversion circuit (CONV) is configured to convert, for each memory cell, the read signal (x(ox)ᵢⱼ) resulting from the second operating configuration (CONF2) into a write control signal (CONT_W<j>) compatible with the first operating configuration (CONF1).

7. The data storage circuit (10) according to any one of claims 2 to 6, wherein the read circuit (CL) comprises a plurality of elementary read circuits (CL<j>), each comprising:
a comparator (COMP) for comparing the read voltage (VBL<j>) and a reference voltage (VREF) in order to supply the read signal (x(fe)ᵢⱼ, x(ox)ᵢⱼ) for the memory cell currently being read.

8. The data storage circuit (10) according to any one of claims 2 to 7, wherein the at least one intermediate storage memory (MEM_INT) is a synchronous flip-flop.

9. The data storage circuit (10) according to any one of claim 7 or 8, wherein the read circuit for each column (Cⱼ) is configured to perform a read operation by executing the following steps:
- selecting the memory cell to be read by putting the selection transistor (T1) corresponding to said memory cell into the on state;
- setting the input/output node (BL<j>) associated with said column to a zero voltage;
- applying a read pulse to the second input node (SL<j>) associated with said column in order to charge the input/output node (BL<j>) associated with the same column;
- comparing the read voltage (VBL<j>) on the input/output node (BL<j>) with the reference voltage (VREF).

10. The data storage circuit (10) according to any one of claims 2 to 6, wherein the read circuit (CL) and the at least one intermediate storage memory (MEM_INT) are formed by a single detection and storage circuit (CL+MEM_INT) comprising:
- a latch flip-flop (LATCH) having two input/output nodes (N'1, N'2);
- a first input node (N1) being intended to receive the reference voltage (VREF) and being connected to the first input/output node (N1') of the latch flip-flop via a first switch (I1);
- a second input node (N2) being intended to receive the read voltage (VBL<j>) and being connected to the second input/output node (N2') of the latch flip-flop via a second switch (I2),
the latch flip-flop (LATCH) being connected to a supply node (NVDD) via a first control transistor (T_{cmd1}) and to electrical earth via a second control transistor (T_{cmd2}).

11. The data storage circuit (10) according to the preceding claim, wherein the read circuit for each column (Cⱼ) is configured to perform a read operation by executing the following steps:
- selecting the memory cell to be read by activating the selection transistor (T1) corresponding to said memory cell;
- setting the input/output node (BL<j>) associated with said column to a zero voltage;
- putting the first and the second switch (I1, I2) into an on state and putting the first and the second control transistor (T_{cmd1}, T_{cmd2}) into an off state in order to deactivate the latch flip-flop (LATCH);
- applying a read pulse to the second input node (SL<j>) associated with said column in order to charge the input/output node (BL<j>) associated with the same column;
- putting the first and the second switch (I1, I2) into an on state in order to compare the read voltage (VBL<j>) on the input/output node (BL<j>) with the reference voltage (VREF) and supply the read signal (x(fe)ᵢⱼ, x(ox)ᵢⱼ);
- putting the first and the second switch (I1, I2) into an off state in order to temporarily store the read signal (x(fe)ᵢⱼ, x(ox)ᵢⱼ).

12. The data storage circuit (10) according to any one of claims 2 to 11, wherein the write circuit is configured to rewrite the data read from a memory cell after each read operation when the first configuration (CONF1) is chosen.

13. The data storage circuit (10) according to any one of claims 2 to 12, wherein the write circuit is configured to apply a write voltage having an amplitude and/or a duration sufficient to establish a conductive filament passing through an irreversible low resistive state.

14. The data storage circuit (10) according to any one of the preceding claims, wherein:
- the first (C1) and third (C3) layers are made of titanium nitride;
- the second layer (C2) is made of silicon-doped hafnium oxide or made of HfZrO₂.

15. A computer (CALC) for executing a computing algorithm involving a plurality of numerical variables (w) according to at least two operating phases,
the first operating phase (Ph1) essentially involving write operations on the numerical variable;
the second operating phase (Ph2) essentially involving read operations on the numerical variable;
said computer (CALC) comprising a data storage circuit (10) according to any one of the preceding claims for storing the numerical variables (w) and wherein:
- the memory cells (BCᵢⱼ) are configured by the control means (CONT) to operate in the first configuration (CONF1) during the execution of the first operating phase;
- the memory cells (BCᵢⱼ) are configured by the control means (CONT) to operate in the second configuration (CONF2) during the execution of the second operating phase.

16. The computer (CALC) according to the preceding claim, configured to implement an artificial neural network, the neural network being formed of a succession of layers (Cₖ, Cₖ₊₁) each consisting of a set of neurons, each layer being associated with a set of synaptic coefficients (wij); wherein:
- the numerical variables are the synaptic coefficients of the neural network;
- the first operating phase is a learning phase;
- the second operating phase is an inference phase.

17. A method for controlling a storage circuit according to any one of claims 3 to 14 to drive the change from the first configuration (CONF1) to the second configuration (CONF2), comprising the following steps for each row of the array of memories:
i. selecting the row of the array of memory cells (100) via the selection signal (VWL<i>);
ii. reading each memory cell and storing each read signal (x(fe)ᵢⱼ) of the row in the intermediate storage memories (MEM_INT) so as to detect the direction of the electrical bias of each memory cell;
iii. applying, to each second input node (SL<j>) of said row, an electric transformation voltage in order to form a conductive filament in the second layer (C2) starting from the third layer (C3) in each memory cell (BCᵢⱼ); said filament corresponding to a high resistive state;
iv. converting the read signals (x(fe)ᵢⱼ) stored in the intermediate storage memories (MEM_INT) during operation in the first configuration (CONF 1) to write control signals compatible with the second configuration (CONF2);
v. writing in the memory cells of said row in accordance with the write control signals compatible with the second configuration (CONF2) so as to vary the length of the conductive filament that is formed.
